# EUROPÄISCHE PATENTANMELDUNG

(11) **EP 1 998 223 A2**
(43) Veröffentlichungstag der Anmeldung: **03.12.2008**
(21) Anmeldenummer: 08000405.4
(22) Anmeldetag: 10.01.2008
(51) Int. Cl.: G03F 7/20

(54) **Projektionsobjektiv für die Lithographie**

(30) Priorität: 23.01.2007 DE 102007005564
(71) Anmelder: Carl Zeiss SMT AG, 73447 Oberkochen (DE)
(72) Erfinder: Feldmann, Heiko, Dr., 73432 Aalen (DE); Beder, Susanne, 73431 Aalen (DE); Dodoc, Aurelian, Dr., 89522 Heidenheim (DE); Epple, Alexander, Dr., 73431 Aalen (DE); Rostalski, Hans-Jürgen, Dr., 73447 Oberkochen (DE)
(74) Vertreter: Heuckeroth, Volker

(57) **Zusammenfassung**

Ein Projektionsobjektiv für die Lithographie weist eine optische Anordnung (12) optischer Elemente zwischen einer Objektebene (O) und einer Bildebene (B) auf, wobei die Anordnung (12) zumindest eine Zwischenbildebene (Z) aufweist, wobei die Anordnung (12) weiterhin zumindest zwei Korrekturelemente (K₁, K₂) zur Korrektur von Abbildungsfehlern aufweist, von denen ein erstes Korrekturelement (K₁) optisch zumindest in Nähe einer Pupillenebene (P) und ein zweites Korrekturelement (K₂) in einem Bereich angeordnet ist, der weder einer Pupillenebene (P) noch einer Feldebene (F) optisch nahe ist (Fig. 1).

## Beschreibung

Die Erfindung betrifft ein Projektionsobjektiv für die Lithographie.

Ein Projektionsobjektiv der vorstehend genannten Art wird im Rahmen der lithographischen, insbesondere mikrolithographischen Herstellung von Halbleitern verwendet, bei der ein mit einer Struktur versehenes Objekt, das auch als Retikel bezeichnet wird, mittels des Projektionsobjektivs auf einen Träger, der als Wafer bezeichnet wird, abgebildet wird. Das mit der Struktur versehene Objekt ist in einer Objektebene des Projektionsobjektivs angeordnet, und der Träger (Wafer) ist in einer Bildebene des Projektionsobjektivs angeordnet. Der Träger ist mit einer photosensitiven Schicht versehen, bei deren Belichtung mittels Licht durch das Projektionsobjektiv hindurch die Struktur des Objekts auf die photosensitive Schicht übertragen wird. Nach Entwickeln der photosensitiven Schicht entsteht die gewünschte Struktur auf dem Träger, wobei der Belichtungsvorgang unter Umständen mehrfach wiederholt wird.

Es sind verschiedene Bauarten von Projektionsobjektiven bekannt, die sich in drei Klassen einteilen lassen. Eine erste Klasse betrifft dioptrische Bauarten, bei denen das Projektionsobjektiv nur refraktive Elemente aufweist. Ein solches dioptrisches Projektionsobjektiv ist aus WO 2004/097911 bekannt.

Eine zweite Klasse von Projektionsobjektiven bilden die katoptrischen Projektionsobjektive, die nur aus reflektiven Elementen aufgebaut sind.

Eine dritte Klasse von Projektionsobjektiven sind die katadioptrischen Projektionsobjektive, deren optische Anordnung optischer Elemente sowohl refraktive als auch reflektive Elemente aufweist. Ein solches katadioptrisches Projektionsobjektiv ist bspw. in Dokument WO 2004/019128 A2 beschrieben.

Die vorliegende Erfindung betrifft unabhängig von der Zuordnung des Projektionsobjektivs zu einer der vorstehend genannten drei Klassen insbesondere solche Projektionsobjektive, die zwischen der Objektebene und der Bildebene zumindest eine Zwischenbildebene aufweisen. In der Zwischenbildebene wird ein Zwischenbild des in der Objektebene angeordneten abzubildenden Objekts erzeugt.

An Projektionsobjektive werden allgemein hohe Anforderungen an ihre Abbildungsqualität gestellt. Diese Anforderungen sind um so höher, je kleiner die durch das Projektionsobjektiv abzubildende Strukturen sind. Daher müssen Projektionsobjektive so weit wie möglich frei von Abbildungsfehlern sein.

Neben den intrinsischen Abbildungsfehlern, die ein Projektionsobjektiv herstellungsbedingt aufweisen kann, können Abbildungsfehler vor allem während des Betriebs des Projektionsobjektivs auftreten, die ihre Ursache überwiegend in einer Veränderung der optischen Elemente durch das durch das Projektionsobjektiv hindurchtretende Abbildungslicht haben. Die Erwärmung der optischen Elemente des Projektionsobjektivs kann zu kurzzeitigen, reversiblen Abbildungsfehlern führen, indem sich bspw. die Form und/oder die Materialeigenschaften (Brechzahl usw.) der optischen Elemente verändern, oder es können Lebensdauereffekte der optischen Elemente auftreten, indem eine dauerhafte Lichteinwirkung die optischen Elemente, bspw. deren Materialdichte, das heißt deren optische Eigenschaften, irreversibel verändert (Kompaktifizierung, Verdünnung).

Es ist allgemein bekannt, dass Abbildungsfehler, die auf Grund der Veränderung der optischen Elemente auftreten und deren Abbildungseigenschaften reversibel oder irreversibel beeinträchtigen, durch Austauschen zumindest eines optischen Elements in dem Projektionsobjektiv zumindest teilweise korrigiert werden können.

Sowohl die intrinsischen als auch während des Betriebs auftretenden Abbildungsfehler können verschiedene Feldverläufe in der Bildebene des Projektionsobjektivs einnehmen. Dabei kann zwischen feldkonstanten Abbildungsfehlern und feldabhängigen Abbildungsfehlern unterschieden werden. Ziel ist es hier, mit möglichst wenigen konstruktiven Maßnahmen während des Betriebs des Projektionsobjektivs sowohl die feldkonstanten als auch die feldabhängigen Abbildungsfehler angreifen zu können.

Wenn Maßnahmen zur Korrektur von Abbildungsfehlern an einem solchen Projektionsobjektiv getroffen werden sollen, sollten diese Maßnahmen in das ursprüngliche Design des Projektionsobjektivs möglichst nicht oder nur wenig eingreifen.

Es ist eine Aufgabe der vorliegenden Erfindung, ein Projektionsobjektiv anzugeben, bei dem mit geringem konstruktiven Aufwand Maßnahmen zur Korrektur von Abbildungsfehlern sowohl mit feldkonstantem Verlauf als auch mit feldabhängigem Verlauf möglich sind.

Erfindungsgemäß wird diese Aufgabe durch ein Projektionsobjektiv einer lithographischen Projektionsbelichtungsanlage gelöst, mit einer optischen Anordnung optischer Elemente zwischen einer Objektebene und einer Bildebene, wobei die Anordnung zumindest eine Zwischenbildebene aufweist, wobei die Anordnung weiterhin zumindest zwei Korrekturelemente zur Korrektur von Abbildungsfehlern aufweist, von denen ein erstes Korrekturelement optisch zumindest in Nähe einer Pupillenebene und ein zweites Korrekturelement in einem Bereich angeordnet ist, der weder einer Pupillenebene noch einer Feldebene optisch nahe ist.

Bei dem erfindungsgemäßen Projektionsobjektiv, dessen optische Anordnung optischer Elemente zwischen der Objektebene und der Bildebene zumindest eine Zwischenbildebene aufweist, sind als Maßnahmen zur Korrektur von Abbildungsfehlern zumindest zwei, vorzugsweise genau zwei oder drei Korrekturelemente zur Korrektur von Abbildungsfehlern vorgesehen, die erfindungsgemäß an bestimmten Positionen des Projektionsobjektivs angeordnet sind. Das erste Korrekturelement ist dabei optisch zumindest in Nähe einer Pupillenebene angeordnet. Darunter ist auch zu verstehen, dass das erste Korrekturelement auch genau in einer Pupillenebene des Projektionsobjektivs angeordnet sein kann. Da die optische Wirkung eines optischen Elements in einer Pupillenebene in der Bildebene des Projektionsobjektivs einen näherungsweise feldkonstanten Verlauf zeigt, können mit dem ersten Korrekturelement Abbildungsfehler mit einem feldkonstanten Verlauf korrigiert werden.

Das zweite Korrekturelement ist dagegen in einem Zwischenbereich angeordnet, das heißt einem Bereich, der weder einer Pupillenebene noch einer Feldebene optisch nahe ist. Ein optisches Element, das in einem solchen Zwischenbereich zwischen Pupille und Feld angeordnet ist, zeigt auf den Verlauf des Bildes in der Bildebene eine optische Wirkung, die sowohl feldkonstante als auch feldabhängige Anteile aufweist. Mit dem zweiten Korrekturelement können somit Abbildungsfehler angegriffen werden, die einen zumindest auch feldabhängigen Verlauf aufweisen.

Unter einer Feldebene ist hier neben der zumindest einen Zwischenbildebene auch die Objektebene und die Bildebene zu verstehen. Ein erfindungsgemäßes Projektionsobjektiv weist somit zumindest drei Feldebenen auf.

Unter dem Begriff "optisch nahe" ist zu verstehen, dass es bei der Position des ersten bzw. zweiten Korrekturelements nicht auf die räumliche Position in Bezug auf die Pupillenebene bzw. auf die Feldebene ankommt, sondern auf die optische Wirkung dieser Position. Eine "optisch nahe" Position ist somit nicht durch den räumlichen Abstand dieser Position von der Pupillenebene oder der Feldebene festgelegt, sondern es kommt lediglich auf die optische Wirkung an, die ein an dieser Position angeordnetes optisches Element auf die Abbildung in die Bildebene besitzt.

In einer bevorzugten Ausgestaltung ist die Position des ersten Korrekturelements so gewählt, dass ein Verhältnis aus Hauptstrahlhöhe zu Randstrahlhöhe an dieser Position dem Betrage nach kleiner als 1/n ist, wobei n = 5, n = 10, oder n = 20 ist.

Unter Hauptstrahlhöhe wird die Strahlhöhe des Hauptstrahles eines Feldpunktes der Objektebene mit betragsmäßig maximaler Feldhöhe verstanden. Unter Randstrahlhöhe wird die Strahlhöhe eines Strahles mit maximaler Apertur ausgehend von der Feldmitte der Objektebene verstanden. Das Verhältnis aus Hauptstrahlhöhe zu Randstrahlhöhe an einer bestimmten Position im Strahlengang des Projektionsobjektivs ist ein Kriterium, nach dem bestimmt werden kann, ob sich diese Position optisch in Nähe einer Pupillenebene oder optisch in Nähe einer Feldebene befindet. Unmittelbar in einer Pupillenebene ist dieses Verhältnis Null und in einer Feldebene sehr viel größer als 1, zumindest größer als 10. Sofern es das ursprüngliche Design des Projektionsobjektivs, an dem die erfindungsgemäßen Korrekturmaßnahmen vorgesehen werden sollen, es nicht erlaubt, das erste Korrekturelement unmittelbar in einer Pupillenebene anzuordnen, wird bei der vorliegenden Ausgestaltung eine Position gesucht, an der das Verhältnis aus Hauptstrahlhöhe zu Randstrahlhöhe kleiner als 1/5 ist.

In einer weiteren bevorzugten Ausgestaltung ist die Position des zweiten Korrekturelements so gewählt, dass ein Verhältnis aus Hauptstrahlhöhe zu Randstrahlhöhe an dieser Position dem Betrage nach größer als 1/m, jedoch kleiner als p/10 ist, wobei m = 20, oder m = 10, oder m = 5, und p = 55, oder p = 35, oder p = 25, oder p = 20, oder p = 17 gilt.

Mit einer solchen Wahl der Position des zweiten Korrekturelements wird vorteilhafterweise gewährleistet, dass sich das zweite Korrekturelement weder einer Pupillenebene noch einer Feldebene optisch nahe befindet.

In bevorzugten Ausgestaltungen des Projektionsobjektivs ist im Fall, dass die Anordnung optischer Element in Lichtausbreitungsrichtung gesehen eine erste Baugruppe, die die Objektebene über eine erste Pupillenebene in die Zwischenbildebene abbildet, und eine zweite Baugruppe aufweist, die die Zwischenbildebene über eine zweite Pupillenebene in die Bildebene abbildet, das erste Korrekturelement optisch zumindest in Nähe der zweiten Pupillenebene und das zweite Korrekturelement nach der Zwischenbildebene und vor der zweiten Pupillenebene angeordnet und weder der Zwischenbildebene noch der zweiten Pupillenebene optisch nahe.

In einer weiteren bevorzugten Ausgestaltung ist im Fall, dass die Anordnung optischer Elemente in Lichtausbreitungsrichtung gesehen eine erste Baugruppe, die die Objektebene über eine erste Pupillenebene in die Zwischenbildebene abbildet und eine zweite Baugruppe aufweist, die das Zwischenbild über eine zweite Pupillenebene in die Bildebene abbildet, das erste Korrekturelement optisch zumindest in Nähe der zweiten Pupillenebene angeordnet und das zweite Korrekturelement vor der ersten Pupillenebene angeordnet und weder zur Objektebene noch zur ersten Pupillenebene optisch nahe.

In einer noch weiteren bevorzugten Ausgestaltung des Projektionsobjektivs ist im Falle, dass die Anordnung optischer Elemente in Lichtausbreitungsrichtung gesehen eine erste Baugruppe, die die Objektebene über eine erste Pupillenebene in eine erste Zwischenbildebene abbildet, eine zweite Baugruppe, die die erste Zwischenbildebene über eine zweite Pupillenebene in eine zweite Zwischenbildebene abbildet, und eine dritte Baugruppe aufweist, die die zweite Zwischenbildebene über eine dritte Pupillenebene in die Bildebene abbildet, das erste Korrekturelement optisch zumindest in Nähe der ersten Pupillenebene und das zweite Korrekturelement zwischen der ersten Pupillenebene und der ersten Zwischenbildebene angeordnet und weder zu der ersten Pupillenebene noch zu der ersten Zwischenbildebene optisch nahe.

In einer noch weiteren bevorzugten Ausgestaltung des Projektionsobjektivs ist im Fall, dass die Anordnung optischer Elemente in Lichtausbreitungsrichtung gesehen eine erste Baugruppe, die die Objektebene über eine erste Pupillenebene in eine Zwischenbildebene abbildet, eine zweite Baugruppe, die die erste Zwischenbildebene über eine zweite Pupillenebene in eine zweite Zwischenbildebene abbildet, und eine dritte Baugruppe aufweist, die die zweite Zwischenbildebene über eine dritte Pupillenebene in die Bildebene abbildet, das erste Korrekturelement optisch zumindest in Nähe der ersten Pupillenebene und das zweite Korrekturelement zwischen der Objektebene und der ersten Pupillenebene angeordnet und weder zur Objektebene noch zur ersten Pupillenebene optisch nahe.

Im Rahmen der zuvor genannten Ausgestaltung des Projektionsobjektivs kann zusätzlich ein drittes Korrekturelement optisch zumindest in Nähe der dritten Pupillenebene angeordnet sein.

In einer noch weiteren bevorzugten Ausgestaltung des Projektionsobjektivs ist im Fall, dass die Anordnung optischer Elemente in Lichtausbreitungsrichtung gesehen eine erste Baugruppe, die die Objektebene über eine erste Pupillenebene in eine erste Zwischenbildebene abbildet, eine zweite Baugruppe, die die erste Zwischenbildebene über eine zweite Pupillenebene in eine zweite Zwischenbildebene abbildet, und eine dritte Baugruppe aufweist, die die zweite Zwischenbildebene über eine dritte Pupillenebene in die Bildebene abbildet, das erste Korrekturelement optisch zumindest in Nähe der dritten Pupillenebene und das zweite Korrekturelement zwischen der Objektebene und der ersten Pupillenebene angeordnet und weder zur Objektebene noch zur ersten Pupillenebene optisch nahe.

In einer noch weiteren bevorzugten Ausgestaltung des Projektionsobjektivs ist im Fall, dass die Anordnung optischer Elemente in Lichtausbreitungsrichtung gesehen eine erste Baugruppe, die die Objektebene über eine erste Pupillenebene in die Zwischenbildebene abbildet, und eine zweite Baugruppe aufweist, die die Zwischenbildebene in die Bildebene abbildet, das erste Korrekturelement optisch zumindest in Nähe der zweiten Pupillenebene und das zweite Korrekturelement zwischen der Objektebene und der ersten Pupillenebene angeordnet und weder der Objektebene noch der ersten Pupillenebene optisch nahe.

Wie bereits oben erwähnt, ist es besonders bevorzugt, wenn die Anordnung genau zwei Korrekturelemente oder drei Korrekturelemente aufweist.

Der Vorteil hierbei besteht darin, dass der Gesamtaufwand für die Korrekturmaßnahmen gering gehalten wird und dennoch ein hohes Korrekturpotenzial zur Korrektur feldkonstanter und feldabhängiger Abbildungsfehler vorhanden ist.

In einer weiteren bevorzugten Ausgestaltung ist zumindest eines der Korrekturelemente während des Betriebs des Projektionsobjektivs austauschbar.

Hierbei ist von Vorteil, dass während des Betriebs des Projektionsobjektivs auf sich während des Betriebs einstellende Abbildungsfehler rasch reagiert werden kann, insbesondere wenn eine Mehrzahl erster Korrekturelemente und eine Mehrzahl zweiter Korrekturelemente bereitgehalten werden, die je nach auftretendem Abbildungsfehler rasch, bspw. über einen Schnellwechsler, gegeneinander ausgetauscht werden können.

Gemäß einer weiteren bevorzugten Ausgestaltung ist zumindest eines der Korrekturelemente eine Planplatte. Vorzugsweise sind beide Korrekturelemente Planplatten.

Gemäß einer weiteren bevorzugten Ausgestaltung weist zumindest eines der Korrekturelemente eine Asphärisierung auf, wobei beide Korrekturelemente eine Asphärisierung aufweisen können.

Zumindest eines der Korrekturelemente ist vorzugsweise aktiv verformbar, wobei in diesem Fall die Korrektur eines oder mehrerer Abbildungsfehler durch Verformung des Korrekturelements während des Betriebs des Projektionsobjektivs erfolgt.

In einer noch weiteren bevorzugten Ausgestaltung ist zumindest eines der Korrekturelemente thermisch manipulierbar.

Hierunter ist zu verstehen, dass das thermisch manipulierbare Korrekturelement mit einer Wärmequelle/Wärmesenke verbunden ist, über die das Korrekturelement erwärmt oder gekühlt werden kann, um dadurch die optische Wirkung des Korrekturelements zur Kompensation eines oder mehrerer Abbildungsfehler geeignet einzustellen.

In einer weiter bevorzugten Ausgestaltung ist zumindest eines der Korrekturelemente lageverstellbar.

Die Lageverstellung kann je nach Anforderung an das Korrekturpotenzial auf eine Verschiebung oder eine Drehung bzw. Verkippung beschränkt sein oder alle möglichen Freiheitsgrade der Translation und Rotation bzw. Verkippung umfassen.

Weitere Vorteile und Merkmale ergeben sich aus der nachfolgenden Beschreibung und der beigefügten Zeichnung.

Es versteht sich, dass die vorstehend genannten und nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in Bezug auf diese hiernach näher beschrieben. Es zeigen:
- Fig. 1: ein ersten Ausführungsbeispiel eines erfindungsgemäßen Projektionsobjektivs;
- Fig. 2: ein weiteres Ausführungsbeispiel eines erfindungsgemäßen Projektionsobjektivs;
- Fig. 3: ein noch weiteres Ausführungsbeispiel eines erfindungsgemäßen Projektionsobjektivs;
- Fig. 4: ein noch weiteres Ausführungsbeispiel eines erfindungsgemäßen Projektionsobjektivs;
- Fig. 5: ein noch weiteres Ausführungsbeispiel eines erfindungsgemäßen Projektionsobjektivs;
- Fig. 6: ein noch weiteres Ausführungsbeispiel eines erfindungsgemäßen Projektionsobjektivs; und
- Fig. 7: ein noch weiteres Ausführungsbeispiel eines erfindungsgemäßen Projektionsobjektivs.

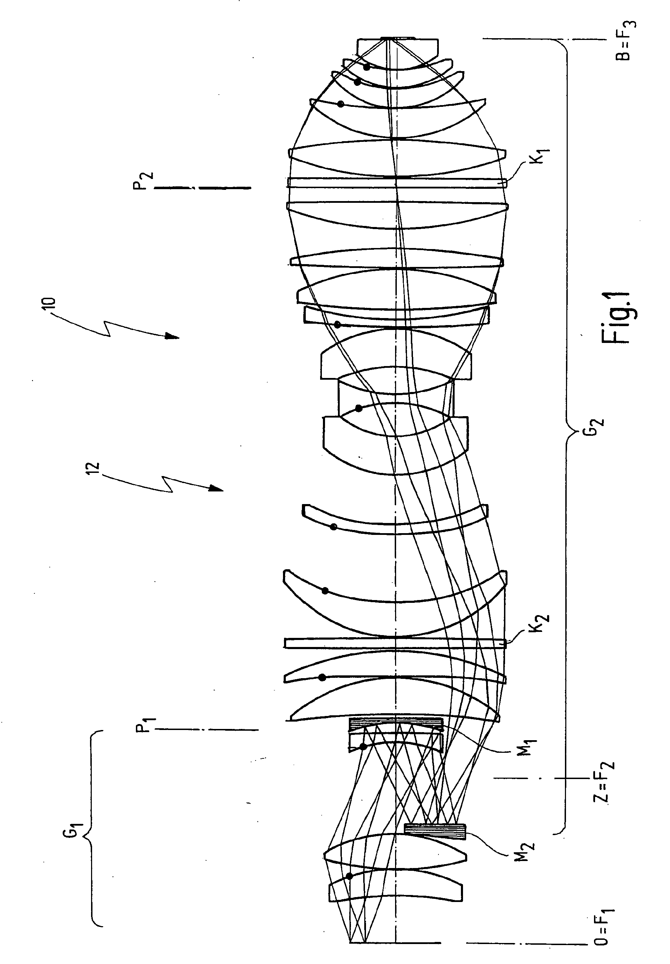

In Fig. 1 ist ein mit dem allgemeinen Bezugszeichen 10 versehenes Projektionsobjektiv dargestellt, das für die lithographische Herstellung von Bauelementen verwendet wird.

Das Projektionsobjektiv 10 weist eine optische Anordnung 12 einer Mehrzahl optischer Elemente zwischen einer Objektebene O und einer Bildebene B auf. Die optische Anordnung 12 weist weiterhin eine Zwischenbildebene Z auf.

Die optische Anordnung 12 des Projektionsobjektivs 10 lässt sich in Lichtausbreitungsrichtung von der Objektebene O zur Bildebene B gesehen in zwei Baugruppen unterteilen, und zwar eine erste Baugruppe G₁ und eine zweite Baugruppe G₂.

Die erste Baugruppe G₁ bildet die Objektebene O bzw. ein in dieser angeordnetes Objekt über eine erste Pupillenebene P₁ in die Zwischenbildebene Z ab. Die erste Baugruppe ist katadioptrisch. Sie weist drei Linsen und zwei Spiegel M₁ und M₂ auf. Die Pupillenebene P₁ befindet sich etwa an der Position des Spiegels M₁.

Die zweite Baugruppe G₂ ist dioptisch und bildet das Zwischenbild Z über eine zweite Pupillenebene P₂ in die Bildebene B ab. Die zweite Baugruppe weist eine Mehrzahl an Linsen auf.

Das Projektionsobjektiv 10, das eine Zwischenbildebene Z aufweist, weist entsprechend drei Feldebenen auf, und zwar die Feldebene F₁, die durch die Objektebene gebildet wird, die Feldebene F₂, die durch die Zwischenbildebene Z gebildet wird, und die Feldebene F₃, die durch die Bildebene B gebildet wird.

Zur Korrektur von Abbildungsfehlern weist die Anordnung 12 zwei Korrekturelemente K₁ und K₂ auf.

Das erste Korrekturelement K₁ ist optisch nahe zur zweiten Pupillenebene P angeordnet. Dabei befindet sich das erste Korrekturelement K₁ nahezu in der Pupillenebene P₂. Das Verhältnis aus Hauptstrahlhöhe zur Randstrahlhöhe ist an der Position des Korrekturelements K₁ nahezu null.

Das zweite Korrekturelement K₂ ist in Lichtausbreitungsrichtung gesehen hinter der Zwischenbildebene und vor der zweiten Pupillenebene angeordnet, und zu keiner dieser beiden Ebenen optisch nahe. Das Verhältnis aus Hauptstrahlhöhe zu Randstrahlhöhe an der Position des Korrekturelements K₂ ist einerseits deutlich von Null verschieden, jedoch andererseits nicht wesentlich größer als Eins.

Die optischen Daten des Projektionsobjektivs 10 sind in der Tabelle 1 zusammengestellt. Der Grundaufbau des Projektionsobjektivs ohne Korrekturelemente ist ferner in US 2006/0256447 A1 beschrieben, auf die wegen weiterer Einzelheiten verwiesen wird.

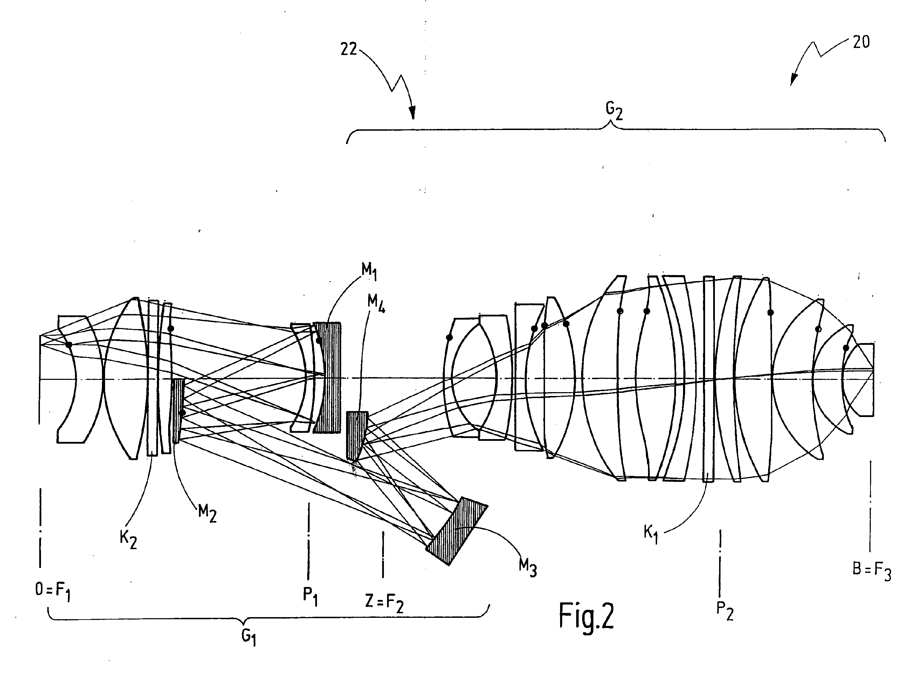

In Fig. 2 ist ein mit dem allgemeinen Bezugszeichen 20 versehenes Projektionsobjektiv dargestellt.

Das Projektionsobjektiv 20 weist zwischen einer Objektebene O und einer Bildebene B eine optische Anordnung 22 mit einer Mehrzahl optischer Elemente auf. Das Projektionsobjektiv 20 weist eine Zwischenbildebene Z auf.

Die Anordnung 22 lässt sich wie bei dem Ausführungsbeispiel in Fig. 1 in zwei Baugruppen unterteilen. Eine erste Baugruppe G₁, die katadioptrisch ist, bildet die Objektebene O über eine erste Pupillenebene P₁ in die Zwischenbildebene Z ab. Die erste Baugruppe G₁ umfasst zwei Spiegel M₁ und M₂.

Eine zweite Baugruppe G₂ bildet das Zwischenbild Z über eine zweite Pupillenebene P₂ in die Bildebene B ab. Die zweite Baugruppe G₂ weist die beiden Spiegel M₃ und M₄ und eine Mehrzahl von Linsen auf und ist somit katadioptrisch.

Zur Korrektur von Abbildungsfehlern weist die Anordnung 22 zwei Korrekturelemente auf, und zwar ein erstes Korrekturelement K₁, das optisch nahe zur zweiten Pupillenebene P₂ angeordnet ist, und zwar an einer Position, an der ein ausreichender Zwischenraum zwischen zwei benachbarten Linsen vorhanden ist.

Ein zweites Korrekturelement K₂ ist zwischen der Objektebene O und der ersten Pupillenebene P₁ angeordnet, wobei die Position des Korrekturelements K₂ so gewählt ist, dass es weder zur Pupillenebene P₁ noch zur Objektebene O optisch nahe ist.

Während das Verhältnis aus Hauptstrahlhöhe zu Randstrahlhöhe an der Position des Korrekturelements K₁ nahe bei Null liegt, liegt dieses Verhältnis an der Position des Korrekturelements K₂ etwa zwischen 0,5 und 2.

Die optischen Daten des Projektionsobjektivs 20 sind in Tabelle 2 zusammengestellt. Der Grundaufbau des Projektionsobjektivs 20 ohne Korrekturelemente ist ferner in US 2006/0256447 A1 beschrieben, auf die wegen weiterer Einzelheiten verwiesen wird.

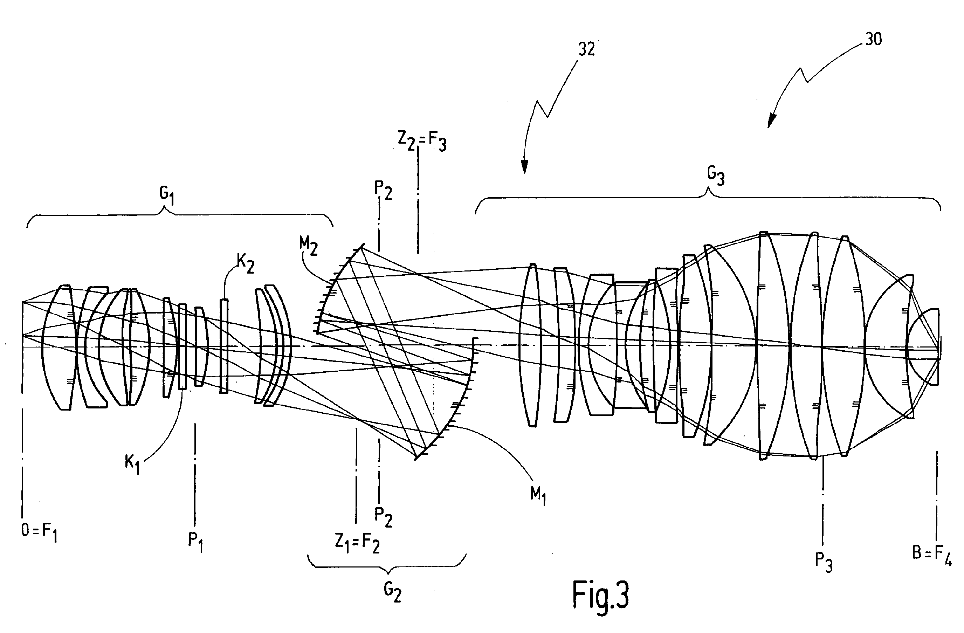

Fig. 3 zeigt ein weiteres Ausführungsbeispiel eines erfindungsgemäßen Projektionsobjektivs 30.

Das Projektionsobjektiv 30 weist zwischen einer Objektebene O und einer Bildebene B eine optische Anordnung 32 aus einer Mehrzahl optischer Elemente auf. Die optischen Elemente umfassen Linsen und Spiegel.

Das Projektionsobjektiv 30 weist insgesamt zwei Zwischenbildebenen Z₁ und Z₂ auf.

Die optische Anordnung 32 lässt sich insgesamt in drei Baugruppen G₁, G₂ und G₃ einteilen.

Die erste Baugruppe G₁ bildet die Objektebene O über eine erste Pupillenebene P₁ in die erste Zwischenbildebene Z₁ ab. Die erste Baugruppe G₁ ist dioptrisch, das heißt, sie besteht nur aus refraktiven Elementen, hier Linsen.

Die zweite Baugruppe G₂ ist katoptrisch, das heißt, besteht nur aus Spiegeln, und zwar den Spiegeln M₁ und M₂. Die zweite Baugruppe G₂ bildet die Zwischenbildebene Z₁ über eine zweite Pupillenebene P₂ in die zweite Zwischenbildebene Z₂ ab.

Die dritte Baugruppe G₃ ist wieder dioptrisch, das heißt, besteht nur aus refraktiven Elementen und bildet die Zwischenbildebene Z₂ in die Bildebene B ab.

Das Projektionsobjektiv 30 weist entsprechend insgesamt vier Feldebenen F₁ bis F₄ auf.

Die Anordnung 32 weist weiterhin ein erstes Korrekturelement K₁ und ein zweites Korrekturelement K₂ auf.

Das erste Korrekturelement K₁ befindet sich der ersten Pupillenebene P₁ optisch nahe. Das zweite Korrekturelement K₂ befindet sich zwischen der ersten Pupillenebene P₁ und der ersten Zwischenbildebene Z₁, ist jedoch weder zur ersten Pupillenebene P₁ noch zur ersten Zwischenbildebene Z₁ optisch nahe. Dies ergibt sich daraus, dass an der Position des Korrekturelements K₂ das Verhältnis aus Hauptstrahlhöhe zu Randstrahlhöhe zwar kleiner als 1, aber deutlich größer als 0 ist, und etwa bei 0,5 liegt.

Die optischen Daten des Projektionsobjektivs 30 sind in Tabelle 3 zusammengestellt. Das Projektionsobjektiv 30 ohne Korrekturelemente ist ferner in WO 2006/055471 A1 beschrieben, auf die wegen weiterer Einzelheiten verwiesen wird.

Wegen des Designs des Projektionsobjektivs 30 bietet sich die dritte Pupillenebene P₃ bzw. der Bereich um die Pupillenebene P₃ nicht zur Anordnung eines Korrekturelements an, da der Abstand zwischen benachbarten Linsen in diesem Bereich zu klein ist.

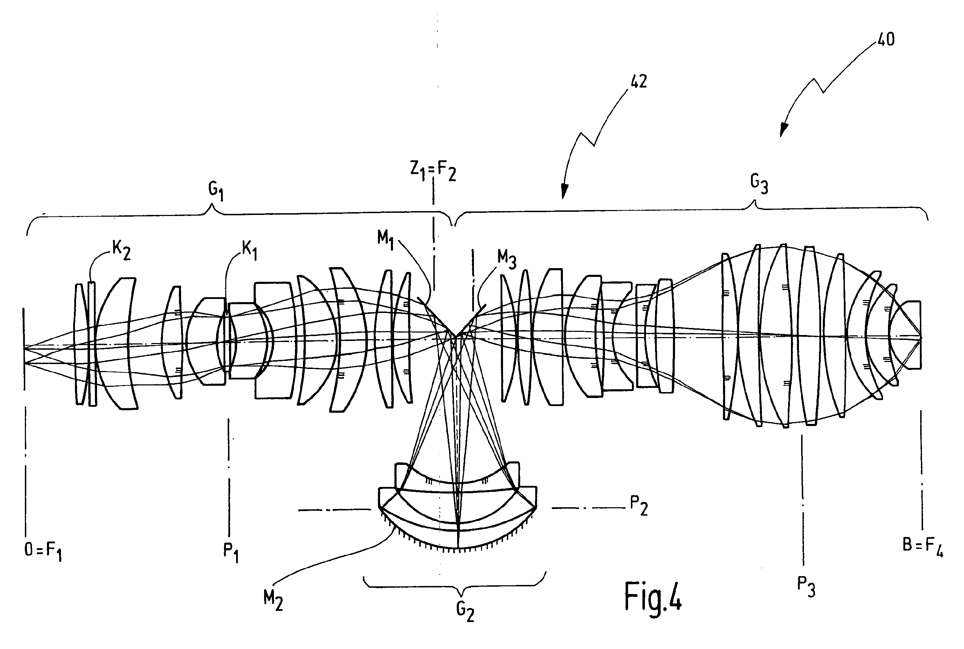

Fig. 4 zeigt ein weiteres Ausführungsbeispiel eines Projektionsobjektivs 40, das eine optische Anordnung 42 aus einer Mehrzahl optischer Elemente, die Linsen und Spiegel umfassen, zwischen einer Objektebene O und einer Bildebene B aufweist.

Das Projektionsobjektiv 40 weist wie das Projektionsobjektiv 30 zwei Zwischenbildebenen Z₁ und Z₂ auf. Des Weiteren weist das Projektionsobjektiv 40 vier Feldebenen F₁ bis F₄ auf.

Die optische Anordnung 42 lässt sich in Lichtausbreitungsrichtung gesehen in die Baugruppen G₁, G₂ und G₃ einteilen.

Die erste Baugruppe G₁ bildet die Objektebene O über eine erste Pupillenebene P₁ in die erste Zwischenbildebene Z₁ ab. Die erste Baugruppe G₁ ist katadioptrisch und weist einen Spiegel M₁ auf.

Die zweite Baugruppe G₂ bildet die erste Zwischenbildebene Z₁ über eine zweite Pupillenebene P₂, die sich an der Position eines Spiegels M₂ befindet, in die zweite Zwischenbildebene Z₂ ab. Die zweite Baugruppe G₂ ist ebenfalls katadioptrisch. Die dritte Baugruppe G₃ bildet die zweite Zwischenbildebene Z₂ über eine dritte Pupillenebene P₃ in die Bildebene B ab. Die dritte Baugruppe G₃ weist einen Spiegel M₃ und eine Mehrzahl an Linsen auf und ist somit katadioptrisch.

Die Anordnung 42 weist zwei Korrekturelemente K₁ und K₂ auf. Das Korrekturelement K₁ ist in der ersten Pupillenebene P₁ angeordnet, und zwar in dem gezeigten Ausführungsbeispiel sogar exakt in der ersten Pupillenebene P₁ zwischen zwei gegenüberliegenden konkaven Linsenoberflächen.

Das zweite Korrekturelement K₂ befindet sich zwischen der Objektebene O und der ersten Pupillenebene P₁, ist aber weder zur Objektebene O noch zur ersten Pupillenebene P₁ optisch nahe. Das Verhältnis aus Hauptstrahlhöhe zu Randstrahlhöhe liegt an der Position des zweiten Korrekturelements K₂ nahe 1.

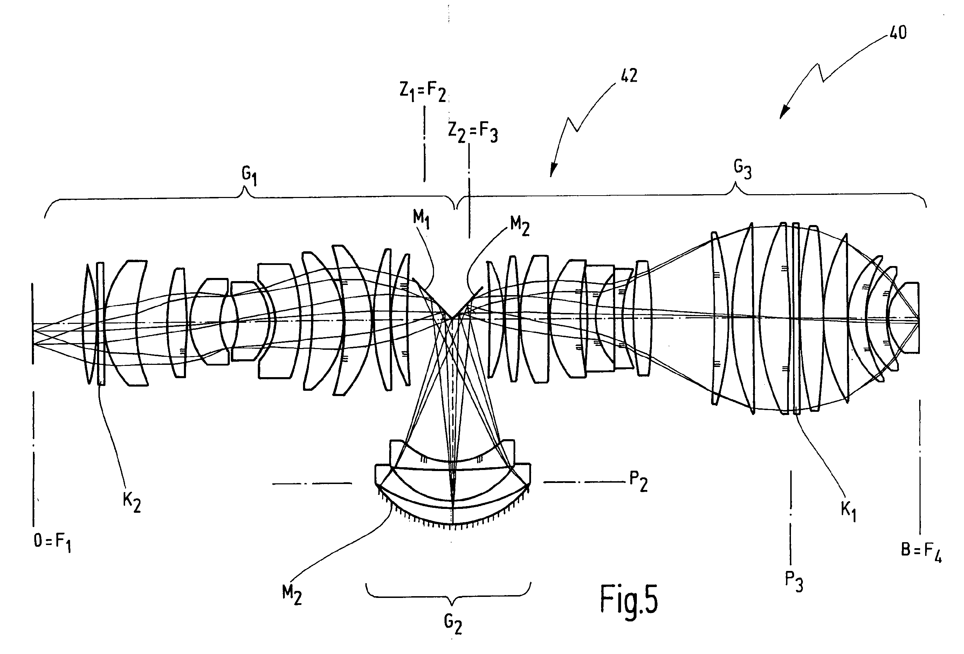

Das Projektionsobjektiv 40 würde es auf Grund seines Designs auch zulassen, das erste Korrekturelement K₁ etwa in der dritten Pupillenebene P₃ anzuordnen, da sich zwischen den beiden Linsen, die beidseits der Pupillenebene P₃ angeordnet sind, ein wenn auch geringer Zwischenraum befindet. Diese Situation ist in Fig. 5 dargestellt.

Die optischen Daten des Projektionsobjektivs 40 gemäß Fig. 4 sind in Tabelle 4 zusammengestellt, während die optischen Daten des Projektionsobjektivs 40 gemäß Fig. 5 mit der entsprechenden anderen Position des ersten Korrekturelements K₁ in Tabelle 5 zusammengestellt sind.

Das Projektionsobjektiv 40 gemäß Figuren 4 und 5, jedoch ohne Korrekturelemente, ist ferner in WO 2004/019128 beschrieben, worauf wegen weiterer Einzelheiten verwiesen wird.

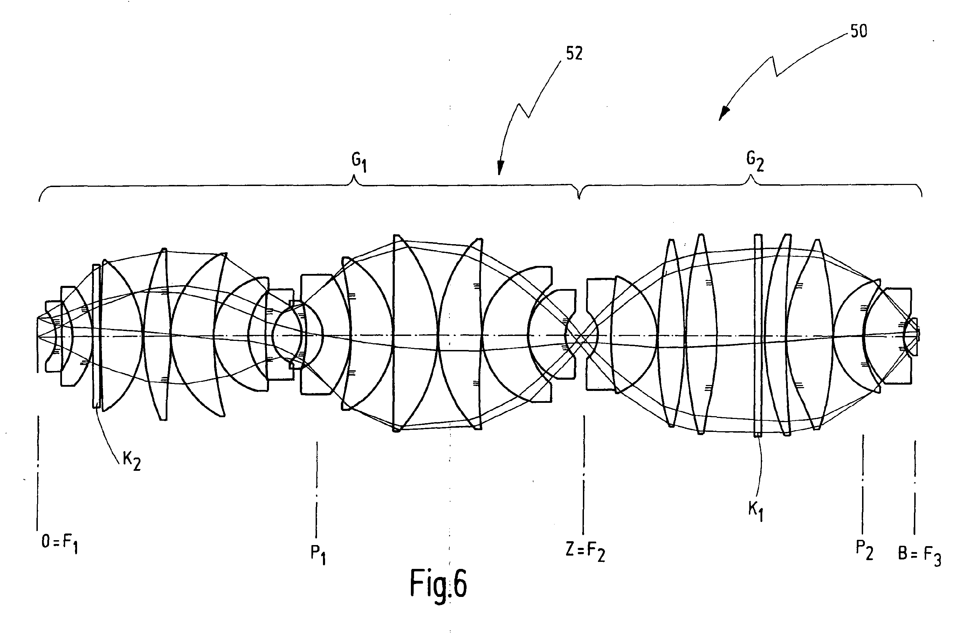

Fig. 6 zeigt ein weiteres Ausführungsbeispiel eines Projektionsobjektivs 50, das im Unterschied zu den zuvor beschriebenen Projektionsobjektiven insgesamt dioptrisch ist, das heißt, nur aus refraktiven Elementen aufgebaut ist.

Das Projektionsobjektiv 50 weist eine optische Anordnung 52 aus einer Mehrzahl an optischen Elementen in Form von Linsen auf, die zwischen einer Objektebene O und einer Bildebene B angeordnet sind.

Die Anordnung 52 weist ein Zwischenbild Z auf und lässt sich in zwei Baugruppen G₁ und G₂ einteilen.

Die erste Baugruppe G₁, die entsprechend dioptrisch ist, bildet die Objektebene O über eine erste Pupillenebene P₁ in die Zwischenbildebene Z ab. Die zweite Baugruppe G₂, ebenfalls dioptrisch, bildet die Zwischenbildebene Z über eine zweite Pupillenebene P₂ in die Zwischenbildebene B ab.

Die Anordnung 52 weist insgesamt zwei Korrekturelemente K₁ und K₂ auf.

Das erste Korrekturelement K₁ ist zur zweiten Pupillenebene P₂ optisch nahe angeordnet. Obwohl das erste Korrekturelement K₁ räumlich von der Pupillenebene P₂ durch drei Linsen beabstandet ist, ist das Korrekturelement K₁ zur Pupillenebene P₂ optisch nahe, da das Verhältnis aus Hauptstrahlhöhe zu Randstrahlhöhe an der Position des Korrekturelements K₁ nur geringfügig von 0 verschieden ist, und zwar etwas kleiner als 1/10 ist.

Das zweite Korrekturelement K₂ befindet sich zwischen der Objektebene O und der ersten Pupillenebene P₁, ist aber weder zur Objektebene O noch zur Pupillenebene P₁ optisch nahe. Das Verhältnis aus Hauptstrahlhöhe zu Randstrahlhöhe ist an der Position des Korrekturelements K₂ nur geringfügig größer als 1.

Die optischen Daten des Projektionsobjektivs 50 sind in Tabelle 6 zusammengestellt. Das Projektionsobjektiv 50 ohne Korrekturelement ist auch in US 2006/0056064 A1 beschrieben, auf die ergänzend verwiesen wird.

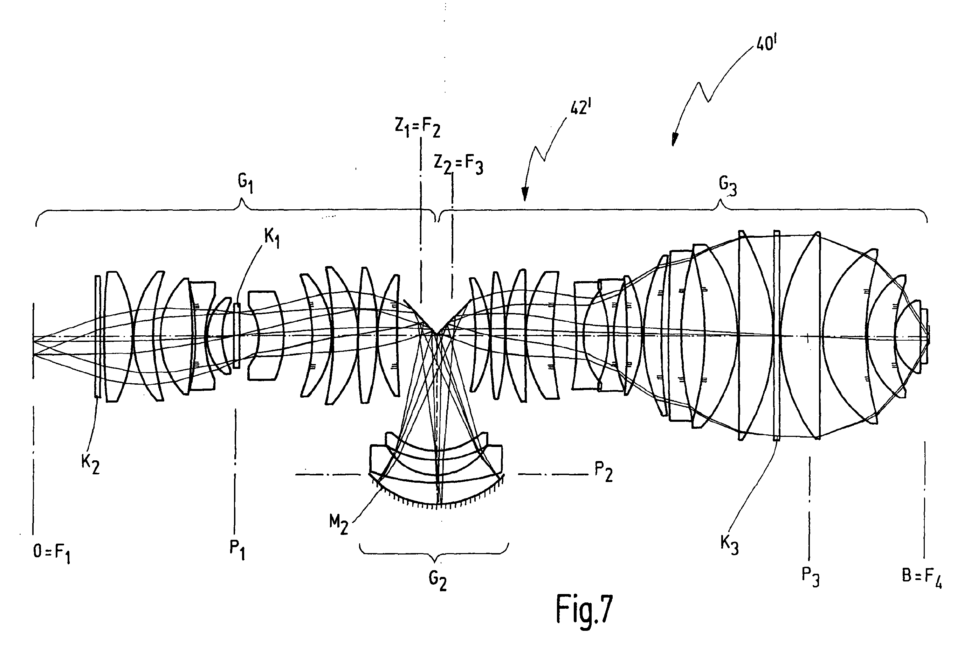

In Fig. 7 ist schließlich noch ein weiteres Ausführungsbeispiel eines Projektionsobjektivs 40' mit einer optischen Anordnung 42' dargestellt. Das in Fig. 7 gezeigte Projektionsobjektiv 40' ist seinem Grundaufbau nach den Ausführungsbeispielen in Fig. 4 und 5 ähnlich, so dass auf die dortige Beschreibung verwiesen werden kann.

Im Unterschied zu den Ausführungsbeispielen in Figuren 4 und 5 weist die optische Anordnung 42' insgesamt drei Korrekturelemente K₁, K₂ und K₃ auf. Das erste Korrekturelement K₁ befindet sich in der ersten Pupillenebene P₁ oder ist zu dieser zumindest optisch nah, und das zweite Korrekturelement K₂ befindet sich zwischen de Objektebene O und der Pupillenebene P₁ an einer Position, die weder zur Objektebene O noch zur Pupillenebene P₁ optisch nahe ist.

Das dritte Korrekturelement K₃ befindet sich optisch nahe der dritten Pupillenebene P₃.

Die optischen Daten des Projektionsobjektivs 40' sind in Tabelle 7 zusammengestellt. Der Grundaufbau des Projektionsobjektivs 40' ohne Korrekturelemente ist in WO 2006/121008 A1 beschrieben, auf die ergänzend verwiesen wird.

Bei allen zuvor beschriebenen Ausführungsbeispielen sind folgende weiteren Maßnahmen vorgesehen.

Das erste Korrekturelement K₁ und/oder das zweite Korrekturelement K₂ und/oder das dritte Korrekturelement K₃ sind während des Betriebs des Projektionsobjektivs 10, 20, 30, 40 oder 50 austauschbar. "Austauschbar" in diesem Sinne heißt, dass die Korrekturelemente K₁ und/oder K₂ und/oder K₃ vorzugsweise über einen Wechslermechanismus aus dem Lichtweg rasch heraus bzw. in den Lichtweg rasch hineingebracht werden können. Es können auch für das erste Korrekturelement K₁ und/oder das zweite Korrekturelement K₂ (und/oder das dritte Korrekturelement K₃) eine Mehrzahl von Austauschkorrekturelementen bereitgehalten werden, die dann mit anderen optischen Eigenschaften ausgestaltet sind, um einen jeweils erfassten Abbildungsfehler am besten korrigieren zu können.

Das erste Korrekturelement K₁ und/oder das zweite Korrekturelement K₂ bzw. das dritte Korrekturelement K₃ sind, wie in Figuren 1 bis 7 dargestellt, vorzugsweise als Planplatten ausgebildet. Die Korrekturelemente K₁ und K₂ bzw. K₃ haben somit keine abbildende optische Wirkung, sondern dienen lediglich zur Korrektur von Abbildungsfehlern. Außerdem lassen sich Planplatten in ein bestehendes Objektivdesign wegen ihres geringen Platzbedarfes besonders günstig mit geringen Änderungen des Objektivdesigns nachträglich einfügen.

Die Korrekturelemente K₁ und/oder K₂ und/oder K₃ können je nach zu erzielender Korrekturwirkung mit einer Asphärisierung vorgesehen sein, und/oder sie können als aktiv verformbare Elemente ausgebildet sein, denen entsprechende Verformungsmanipulatoren zugeordnet sind, und/oder sie können auch mit thermischen Manipulatoren versehen sein, die die Korrekturelemente K₁ und/oder K₂ und/oder K₃ erwärmen oder abkühlen, um die erwünschte optische Korrekturwirkung in den Korrekturelementen K₁ und/oder K₂ und/oder K₃ einzustellen. Des Weiteren können die Korrekturelemente K₁ und/oder K₂ und/oder K₃ zur Erzielung einer bestimmten optischen Korrekturwirkung lageverstellbar ausgebildet sein, wobei den Korrekturelementen K₁ und/oder K₂ und/oder K₃ entsprechende Manipulatoren zur Lageverstellung zugeordnet sind. Die Lageverstellung kann in Verschiebungen in Lichtausbreitungsrichtung, quer zur Lichtausbreitungsrichtung oder in Überlagerungen dieser beiden Richtungen, in Drehungen, Verkippungen usw. bestehen.

Das erste Korrekturelement K₁, das stets in Nähe einer Pupillenebene angeordnet ist, dient zur Korrektur von feldkonstanten Abbildungsfehlern, während das Korrekturelement K₂, das stets in einem Zwischenbereich zwischen einer Feldebene und einer Pupillenebene angeordnet ist, zur Korrektur von Abbildungsfehlern dient, die zumindest auch feldabhängige Anteile aufweisen.

**Tabelle 1**

| NA: 1.2, Feld: A = 26 mm, B = 5.5, R = 11.5 mm ,WL 193,368 nm | | | | | | |
|---|---|---|---|---|---|---|
| FLAECHE | RADIEN | | DICKEN | GLAESER | 193.368 nm | 1/2DURCHM |
| 0 | 0.0 | | 78.303613 | AIR | 1.00000000 | 68.000 |
| 1 | -394.191214 | | 41.739707 | SIO2 | 1.56078570 | 89.318 |
| 2 | -198.169616 | AS | 0.996922 | AIR | 1.00000000 | 97.224 |
| 3 | 446.404208 | | 56.197179 | SIO2 | 1.56078570 | 105.457 |
| 4 | -184.168849 | | 146.744728 | AIR | 1.00000000 | 105.917 |
| 5 | -160.246412 | AS | 14.998293 | CAF2 | 1.50185255 | 53.242 |
| 6 | -1617.196824 | | 15.111401 | AIR | 1.00000000 | 63.827 |
| 7 | -207.292891 | | -15.111401 | REFL | 1.00000000 | 67.705 |
| 8 | -1617.196824 | | -14.998293 | CAF2 | 1.50185255 | 67.674 |
| 9 | -160.246412 | AS | -131.745949 | AIR | 1.00000000 | 67.172 |
| 10 | -3715.402662 | AS | 176.854423 | REFL | 1.00000000 | 91.197 |
| 11 | -1112.237530 | | 60.308635 | SIO2 | 1.56078570 | 151.888 |
| 12 | -229.362794 | | 1.203111 | AIR | 1.00000000 | 155.623 |
| 13 | -3717.820612 | AS | 42.208898 | SIO2 | 1.56078570 | 163.490 |
| 14 | -347.352770 | | 3.017120 | AIR | 1.00000000 | 165.417 |
| 15 | 0.000000 | | 15.000000 | SIO2 | 1.56078570 | 165.592 |
| 16 | 0.000000 | | 3.026023 | AIR | 1.00000000 | 165.630 |
| 17 | 202.325441 | | 57.054809 | SIO2 | 1.56078570 | 165.979 |
| 18 | 364.549775 | AS | 112.911698 | AIR | 1.00000000 | 157.356 |
| 19 | 523.345363 | AS | 14.104445 | SIO2 | 1.56078570 | 136.685 |
| 20 | 273.861634 | | 81.489838 | AIR | 1.00000000 | 129.939 |
| 21 | 155.304364 | | 65.231336 | SIO2 | 1.56078570 | 105.552 |
| 22 | 127.633723 | | 54.935139 | AIR | 1.00000000 | 80.523 |
| 23 | -227.097829 | AS | 13.016244 | SIO2 | 1.56078570 | 78.928 |
| 24 | 182.536777 | | 46.455888 | AIR | 1.00000000 | 84.166 |
| 25 | -207.182814 | | 61.528057 | SIO2 | 1.56078570 | 87.897 |
| 26 | -176.528856 | | 0.993891 | AIR | 1.00000000 | 110.784 |
| 27 | 865.127053 | AS | 12.999101 | SIO2 | 1.56078570 | 130.528 |
| 28 | 415.920005 | | 19.152224 | AIR | 1.00000000 | 136.921 |
| 29 | 1097.434748 | | 63.443284 | SIO2 | 1.56078570 | 140.520 |
| 30 | -336.168712 | | 0.998659 | AIR | 1.00000000 | 147.380 |
| 31 | 2299.996269 | | 35.799374 | SIO2 | 1.56078570 | 157.767 |
| 32 | -716.010845 | | 29.177622 | AIR | 1.00000000 | 159.443 |
| 33 | 451.524671 | | 46.260303 | SIO2 | 1.56078570 | 166.030 |
| 34 | -3021.353828 | | -2.567508 | AIR | 1.00000000 | 165.137 |
| 35 | 0.000000 | | 0.000000 | AIR | 1.00000000 | 164.803 |
| 36 | 0.000000 | | 23.628165 | AIR | 1.00000000 | 164.803 |
| 37 | 0.000000 | | 15.000000 | SIO2 | 1.56078570 | 163.773 |
| 38 | 0.000000 | | 1.001035 | AIR | 1.00000000 | 163.354 |
| 39 | 422.935081 | | 60.555463 | SIO2 | 1.56078570 | 161.905 |
| 40 | -852.100717 | | 0.999943 | AIR | 1.00000000 | 159.604 |
| 41 | 189.766568 | | 49.041357 | SIO2 | 1.56078570 | 131.068 |
| 42 | 708.548829 | AS | 0.999918 | AIR | 1.00000000 | 125.218 |
| 43 | 126.232399 | | 30.801444 | SIO2 | 1.56078570 | 97.429 |
| 44 | 170.774778 | AS | 0.997967 | AIR | 1.00000000 | 87.907 |
| 45 | 115.264122 | | 28.743458 | CAF2 | 1.50185255 | 79.319 |
| 46 | 172.796848 | AS | 0.989848 | AIR | 1.00000000 | 66.334 |
| 47 | 95.876561 | | 47.472181 | SIO2 | 1.56078570 | 57.697 |
| 48 | 0.000000 | | 0.000000 | IMM | 1.43667693 | 23.674 |
| 49 | 0.000000 | | 3.000000 | SIO2 | 1.56078570 | 23.674 |
| 50 | 0.000000 | | 1.996512 | IMM | 1.43667693 | 20.051 |
| 51 | 0.000000 | | 0.000000 | AIR | 0.00000000 | 17.000 |

| | | | | | | |
|---|---|---|---|---|---|---|
| | | | | | | |

| ASPHAERISCHE KONSTANTEN | | | | | | |
|---|---|---|---|---|---|---|
| | | | | | | |
| SRF | 2 | 5 | 9 | 10 | 13 | |
| K | 0 | 0 | 0 | 0 | 0 | |
| C1 | 1.392433e-09 | 1.801887e-08 | 1.801887e-08 | -1.280168e-09 | -1.440880e-10 | |
| C2 | -2.808823e-13 | 7.546535e-13 | 7.546535e-13 | -4.640590e-17 | -4.234605e-13 | |
| C3 | -1.371628e-18 | 2.174176e-17 | 2.174176e-17 | -8.894827e-18 | 4.084291e-18 | |
| C4 | 1.424663e-20 | 7.624607e-22 | 7.624607e-22 | 2.947352e-22 | 5.565576e-23 | |
| C5 | 6.348497e-26 | -1.141362e-25 | -1.141362e-25 | -1.966904e-26 | -3.040396e-27 | |
| C6 | 5.204122e-29 | 3.028426e-29 | 3.028426e-29 | -1.184645e-31 | 2.543798e-32 | |
| C7 | 0.000000e+00 | 0.000000e+00 | 0.000000e+00 | 0.000000e+00 | 0.000000e+00 | |
| C8 | 0.000000e+00 | 0.000000e+00 | 0.000000e+00 | 0.000000e+00 | 0.000000e+00 | |
| C9 | 0.000000e+00 | 0.000000e+00 | 0.000000e+00 | 0.000000e+00 | 0.000000e+00 | |
| | | | | | | |
| SRF | 18 | 19 | 23 | 27 | 42 | |
| K | 0 | 0 | 0 | 0 | 0 | |
| C1 | 2.672810e-08 | 2.775005e-08 | -1.669000e-07 | -1.217647e-08 | 9.547564e-09 | |
| C2 | -3.860076e-13 | -4.185969e-13 | -2.863948e-12 | 1.744126e-13 | 3.052025e-14 | |
| C3 | -4.016442e-19 | 1.241612e-17 | 5.822813e-17 | -4.293560e-18 | -1.353704e-17 | |
| C4 | 7.404508e-22 | 1.372267e-21 | -1.894875e-21 | 2.525946e-22 | 1.116101e-21 | |
| C5 | -2.355249e-26 | -5.426320e-26 | -6.837523e-25 | -7.956605e-27 | -3.620235e-26 | |
| C6 | 3.556112e-31 | 1.048616e-30 | 1.669138e-29 | 2.582110e-31 | 7.221257e-31 | |
| C7 | 0.000000e+00 | 0.000000e+00 | 0.000000e+00 | 0.000000e+00 | 0.000000e+00 | |
| C8 | 0.000000e+00 | 0.000000e+00 | 0.000000e+00 | 0.000000e+00 | 0.000000e+00 | |
| C9 | 0.000000e+00 | 0.000000e+00 | 0.000000e+00 | 0.000000e+00 | 0.000000e+00 | |
| | | | | | | |
| SRF | 44 | 46 | | | | |
| K | 0 | 0 | | | | |
| C1 | 7.852231e-10 | 8.538916e-08 | | | | |
| C2 | -7.474578e-14 | 3.992913e-12 | | | | |
| C3 | 1.525417e-16 | -7.180100e-16 | | | | |
| C4 | 8.737198e-21 | 3.099598e-22 | | | | |
| C5 | -1.853350e-25 | -9. 334126e-24 | | | | |
| C6 | 2.659521e-29 | 1.130507e-27 | | | | |
| C7 | 0.000000e+00 | 0.000000e+00 | | | | |
| C8 | 0.000000e+00 | 0.000000e+00 | | | | |
| C9 | 0.000000e+00 | 0.000000e+00 | | | | |
| | | | | | | |

**Tabelle 2**

| NA: 1.3, Feld: A = 26 mm, B = 4, R = 14 mm ,WL 193,368 nm | | | | | | |
|---|---|---|---|---|---|---|
| FLAECHE | RADIEN | | DICKEN | GLAESER | INDEX | 1/2 DURCHME |
| 0 | 0.0 | | 57.601464 | AIR | 1.00000000 | 72.000 |
| 1 | -119.598919 | AS | 40.752708 | SIO2 | 1.56078570 | 82.269 |
| 2 | -210.232462 | | 2.023855 | AIR | 1.00000000 | 101.057 |
| 3 | 215.685827 | | 66.865592 | SIO2 | 1.56078570 | 128.153 |
| 4 | -579.527028 | | 0.998419 | AIR | 1.00000000 | 127.473 |
| 5 | 0.000000 | | 15.000000 | SIO2 | 1.56078570 | 123.835 |
| 6 | 0.000000 | | 2.075403 | AIR | 1.00000000 | 121.571 |
| 7 | 1216.286957 | | 18.228954 | SIO2 | 1.56078570 | 119.661 |
| 8 | -869.049699 | AS | 210.065231 | AIR | 1.00000000 | 117.523 |
| 9 | -154.503018 | | 12.995617 | SIO2 | 1.56078570 | 80.708 |
| 10 | -558.821838 | | 16.017211 | AIR | 1.00000000 | 85.674 |
| 11 | -235.158769 | AS | -16.017211 | REFL | 1.00000000 | 87.766 |
| 12 | -558.821838 | | -12.995617 | SIO2 | 1.56078570 | 85.404 |
| 13 | -154.503018 | | -190.064030 | AIR | 1.00000000 | . 76.527 |
| 14 | -830.589177. | AS | 486.673979 | REFL | 1.00000000 | 98.568 |
| 15 | -410.985202 | | -193.020300 | REFL | 1.00000000 | 273.647 |
| 16 | -437.290174 | | 113.125152 | REFL | 1.00000000 | 135.926 |
| 17 | 267.646367 | AS | 12.998513 | SIO2 | 1.56078570 | 95.142 |
| 18 | 109.319044 | | 71.810108 | AIR | 1.00000000 | 84.288 |
| 19 | -155.678245 | | 24.706124 | SIO2 | 1.56078570 | 85.404 |
| 20 | -543.272055 | | 4.335390 | AIR | 1.00000000 | 99.062 |
| 21 | 24445.217145 | | 13.950217 | SIO2 | 1.56078570 | 104.821 |
| 22 | 196.548934 | AS | 32.737178 | AIR | 1.00000000 | 116.137 |
| 23 | -1380.847087 | AS | 47.097422 | SIO2 | 1.56078570 | 124.268 |
| 24 | -312.879094 | AS | 12'.293161 | AIR | 1.00000000 | 129.120 |
| 25 | 270.274855 | | 55.849255 | SIO2 | 1.56078570 | 162.524 |
| 26 | -38956.530667 | AS | 29.047600 | AIR | 1.00000000 | 161.278 |
| 27 | 309.940005 | AS | 62.710725 | SIO2 | 1.56078570 | 161.189 |
| 28 | -465.378574 | | 12.984279 | AIR | 1.00000000 | 161.962 |
| 29 | -423.245186 | | 17.988269 | SIO2 | 1.56078570 | 160.698 |
| 30 | -775.040675 | | 12.095938 | AIR | 1.00000000 | 162.998 |
| 31 | 0.000000 | | 15.000000 | SIO2 | 1.56078570 | 162.730 |
| 32 | 0.000000 | | 26.456480 | AIR | 1.00000000 | 162.643 |
| 33 | 0.000000 | | 0.000000 | AIR | 1.00000000 | 162.629 |
| 34 | 0.000000 | | -24.103637 | AIR | 1.00000000 | 162.629 |
| 35 | 469.264272 | | 28.933015 | SIO2 | 1.56078570 | 163.056 |
| 36 | 1247.953833 | | 1.106804 | AIR | 1.00000000 | 162.501 |
| 37 | 330.026166 | | 57.681933 | SIO2 | 1.56078570 | 162.159 |
| 38 | -3249.855106 | AS | 0.998349 | AIR | 1.00000000 | 160.138 |
| 39 | 154.864461 | | 61.102740 | SIO2 | 1.56078570 | 128.336 |
| 40 | 498.034349 | AS | 0.993535 | AIR | 1.00000000 | 121.162 |
| 41 | 100.640590 | | 44.902715 | SIO2 | 1.56078570 | 87.015 |
| 42 | 256.488347 | AS | 0.971666 | AIR | 1.00000000 | 74.934 |
| 43 | 84.324806 | | 47.078122 | SIO2 | 1.56078570 | 57.364 |
| 44 | 0.000000 | | 1.000000 | WATER | 1.43667693 | 20.148 |
| 45 | 0.000000 | | 0.000000 | AIR | 0.00000000 | 18.001 |

| ASPHAERISCHE KONSTANTEN | | | | | | |
|---|---|---|---|---|---|---|
| | | | | | | |
| SRF | 1 | 8 | 11 | 14 | 17 | |
| K | 0 | 0 | 0 | 0 | 0 | |
| C1 | 8.239862e-08 | 3.538306e-08 | -3.277327e-09 | -2.744235e-09 | -2.398764e-08 | |
| C2 | 2.337982e-12 | -4.151996e-13 | -1.091434e-13 | 1.866716e-13 | 1.254301e-12 | |
| C3 | 3.678382e-16 | 5.769308e-17 | -1.991536e-18 | -5.960771e-18 | 2.037512e-16 | |
| C4 | -2.223105e-20 | -2.411453e-21 | 2.984786e-24 | 3.073631e-22 | -4.065121e-20 | |
| C5 | 3.007844e-24 | 6.269400e-26 | -6.132545e-27 | -1.291587e-26 | 3.021671e-24 | |
| C6 | -6.701338e-29 | 4.859807e-31 | -3.611404e-32 | 2.791406e-31 | -8.808337e-29 | |
| C7 | 0.000000e+00 | 0.000000e+00 | 0.000000e+00 | 0.000000e+00 | 0.000000e+00 | |
| C8 | 0.000000e+00 | 0.000000e+00 | 0.000000e+00 | 0.000000e+00 | 0.000000e+00 | |
| C9 | 0.000000e+00 | 0.000000e+0 | 0.000000e+00 | 0.000000e+00 | 0.000000e+00 | |
| | | | | | | |
| SRF | 22 | 23 | 24 | 26 | 27 | |
| K | 0 | 0 | 0 | 0 | 0 | |
| C1 | -2.584292e-08 | 5.067971e-08 | -1.189020e-08 | 2.911874e-08 | -2.946438e-08 | |
| C2 | -7.177953e-13 | 4.809462e-13 | 5.053313e-13 | -4.562463e-13 | 4.758206e-18 | |
| C3 | -1.126960e-16 | -8.588772e-17 | -2.469630e-17 | 7.920650e-18 | -1.104714e-17 | |
| C4 | 1.096561e-20 | 1.523536e-23 | -7.975852e-23 | -2.806318e-22 | 7.483230e-23 | |
| C5 | -4.053220e-25 | 1.203472e-25 | -1.085094e-26 | 5.644206e-27 | -2.311461e-27 | |
| C6 | 4.947334e-30 | -1.922187e-30 | -8.830951e-31 | -7.020347e-32 | -4.536924e-32 | |
| C7 | 0.000000e+00 | 0.000000e+00 | 0.000000e+00 | 0.000000e+00 | 0.000000e+00 | |
| C8 | 0.000000e+00 | 0.000000e+00 | 0.000000e+00 | 0.000000e+00 | 0.000000e+00 | |
| C9 | 0.000000e+00 | 0.000000e+00 | 0.000000e+00 | 0.000000e+00 | 0.000000e+00 | |
| | | | | | | |
| SRF | 38 | 40 | 42 | | | |
| K | 0 | 0 | 0 | | | |
| C1 | 1.303063e-08 | -1.311818e-11 | 8.781384e-08 | | | |
| C2 | -8.717504e-13 | 1.825033e-12 | 9.514823e-12 | | | |
| C3 | 1.035440e-17 | -2.385113e-16 | -6.587823e-16 | | | |
| C4 | 9.879529e-23 | 1.880562e-20 | 4.013727e-20 | | | |
| C5 | -2.114495e-27 | -7.119989e-25 | 1.218883e-24 | | | |
| C6 | 1.566842e-33 | 1.177690e-29 | -6.344699e-28 | | | |
| C7 | 0.000000e+00 | 0.000000e+00 | 0.000000e+00 | | | |
| C8 | 0.000000e+00 | 0.000000e+00 | 0.000000e+00 | | | |
| C9 | 0.000000e+00 | 0.000000e+00 | 0.000000e+00 | | | |

**Tabelle 3**

| NA: 1.35 ; Feld: 26 mm x 5,5 mm ; WL 193,368 nm | | | | | | |
|---|---|---|---|---|---|---|
| FLAECHE | RADIEN | | DICKEN | GLAESER | 193.368 nm | 1/2 DURCHM |
| 0 | 0.000000 | | 30.000000 | | 1.00000000 | 63.500 |
| 1 | 155.500468 | | 47.980384 | SIO2 | 1.56018811 | 82.822 |
| 2 | -333.324258 | AS | 1.000851 | | 1.00000000 | 82.263 |
| 3 | 240.650949 | | 10.194017 | SIO2 | 1.56018811 | 79.900 |
| 4 | 106.801800 | | 20.365766 | | 1.00000000 | 74.667 |
| 5 | 124.630972 | | 34.680113 | SIO2 | 1.56018811 | 79.588 |
| 6 | 468.398192 | | 11.981603 | | 1.00000000 | 77.781 |
| 7 | 380.553803 | AS | 26.909838 | SIO2 | 1.56018811 | 77.238 |
| 8 | -171.820449 | | 19.336973 | | 1.00000000 | 77.050 |
| 9 | -3157.552773 | | 18.733166 | SIO2 | 1.56018811 | 63.691 |
| 10 | -201.010840 | AS | 2.828885 | | 1.00000000 | 61.535 |
| 11 | 0.000000 | | 10.000000 | SIO2 | 1.56018811 | 54.631 |
| 12 | 0.000000 | | 14.057031 | | 1.00000000 | 51.301 |
| 13 | -675.142412 | | 17.151908 | SIO2 | 1.56018811 | 45.967 |
| 14 | -177.431040 | | 17.484199 | | 1.00000000 | 49.621 |
| 15 | 0.000000 | | 10.000000 | SIO2 | 1.56018811 | 57.648 |
| 16 | 0.000000 | | 48.376949 | | 1.00000000 | 59.680 |
| 17 | -339.503853 | | 22.085648 | SIO2 | 1.56018811 | 72.901 |
| 18 | -153.734447 | | 9.426343 | | 1.00000000 | 75.785 |
| 19 | -133.551892 | | 10.000178 | SIO2 | 1.56018811 | 76.547 |
| 20 | -159.012061 | | 260.928174 | | 1.00000000 | 80.555 |
| 21 | -186.269426 | AS | -223.122910 | REFL | 1.00000000 | 159.966 |
| 22 | 171.856468 | AS | 290.241437 | REFL | 1.00000000 | 137.560 |
| 23 | 418.208640 | | 33.119326 | SIO2 | 1.56018811 | 109.835 |
| 24 | -764.923828 | | 24.991712 | | 1.00000000 | 109.215 |
| 25 | -933.573206 | | 23.101710 | SIO2 | 1.56018811 | 104.458 |
| 26 | 1486.991752 | AS | 3.727360 | | 1.00000000 | 103.086 |
| 27 | 264.108066 | | 15.536565 | SIO2 | 1.56018811 | 94.140 |
| 28 | 124.187755 | | 40.232391 | | 1.00000000 | 84.090 |
| 29 | -905.198558 | AS | 11.197639 | SIO2 | 1.56018811 | 83.893 |
| 30 | 131.424652 | | 22.232119 | | 1.00000000 | 82.631 |
| 31 | 288.907138 | AS | 18.371287 | SIO2 | 1.56018811 | 85.149 |
| 32 | 1443.815086 | | 26.039370 | | 1.00000000 | 87.978 |
| 33 | -219.723661 | | 10.212957 | SIO2 | 1.56018811 | 90.084 |
| 34 | -505.370348 | AS | 1.495833 | | 1.00000000 | 104.533 |
| 35 | 602.513212 | AS | 45.614756 | SIO2 | 1.56018811 | 113.361 |
| 36 | -381.370078 | | 0.999817 | | 1.00000000 | 124.374 |
| 37 | -3646.793540 | AS | 62.876806 | SIO2 | 1.56018811 | 133.446 |
| 38 | -186.442382 | | 0.999658 | | 1.00000000 | 138.789 |
| 39 | 803.321916 | AS | 47.355581 | SIO2 | 1.56018811 | 156.646 |
| 40 | -403.820101 | | 0.999375 | | 1.00000000 | 158.048 |
| 41 | 464.394742 | | 43.310049 | SIO2 | 1.56018811 | 156.920 |
| 42 | -28298.847889 | AS | 5.923544 | | 1.00000000 | 155.749 |
| 43 | 0.000000 | | -4.924437 | | 1.00000000 | 153.985 |
| 44 | 452.887984 | | 57.784133 | SIO2 | 1.56018811 | 151.449 |
| 45 | -566.954376 | AS | 1.000000 | | 1.00000000 | 149.326 |
| 46 | 114.038890 | | 60.833075 | SIO2 | 1.56018811 | 99.518 |
| 47 | 1045.400093 | AS | 1.000000 | | 1.00000000 | 90.060 |
| 48 | 61.105427 | | 43.354396 | SIO2 | 1.56018811 | 51.240 |
| 49 | 0.000000 | | 3.100000 | H2O | 1.43618227 | 24.415 |
| 50 | 0.000000 | | 0.000000 | H2O | 1.43618227 | 15.875 |

| ASPHAERISCHE KONSTANTEN | | | | | | |
|---|---|---|---|---|---|---|
| | | | | | | |
| FLAECHE | 2 | 7 | 10 | 21 | 22 | |
| | | | | | | |
| K | 0 | 0 | 0 | -2.1798 | -0.6806 | |
| C1 | 6.256157E-08 | -3.919709E-07 | -1.057407E-07 | -3.488371E-08 | 7.086654E-09 | |
| C2 | 3.982916E-12 | 2.095591 E-11 | 4.580617E-11 | 2.874848E-13 | 1.057963E-13 | |
| C3 | -9.451716E-16 | 9.822817E-16 | -9.115065E-15 | -9.162279E-18 | 1.491672E-18 | |
| C4 | 1.335061E-19 | -1.667379E-20 | 3.329325E-18 | 1.681271E-22 | 1.625713E-23 | |
| C5 | -1.301313E-23 | -4.323686E-23 | -7.843408E-22 | -3.708622E-27 | 4.834151E-28 | |
| C6 | 8.344361E-28 | 5.150093E-27 | 1.064851E-25 | 4.914613E-32 | -3.211541E-33 | |
| C7 | -2.584534E-32 | -2.098245E-31 | -6.440967E-30 | -4.062945E-37 | 1.425318E-37 | |
| C8 | 0.000000E+00 | 0.000000E+00 | 0.000000E+00 | 0.000000E+00 | 0.000000E+00 | |
| C9 | 0.000000E+00 | 0.000000E+00 | 0.000000E+00 | 0.000000E+00 | 0.000000E+00 | |
| | | | | | | |
| FLAECHE | 26 | 29 | 31 | 34 | 35 | |
| | | | | | | |
| K | 0 | 0 | 0 | 0 | 0 | |
| C1 | -2.253603E-07 | 2.933385E-08 | 4.633569E-09 | 1.036685E-07 | -4.703595E-08 | |
| C2 | 1.351029E-11 | 3.990857E-13 | -4.997364E-12 | 2.758011 E-12 | 4.159400E-12 | |
| C3 | 3.795789E-17 | -6.050500E-17 | 4.889637E-16 | -3.278071 E-16 | -3.908920E-16 | |
| C4 | -7.421214E-20 | 1.255229E-19 | -1.484469E-19 | -2.153010E-20 | 1.644386E-20 | |
| C5 | 6.117939E-24 | -1.877429E-23 | 1.977553E-23 | 1.089767E-24 | -1.808670E-25 | |
| C6 | -2.347293E-28 | 1.072691E-27 | -1.918985E-27 | 6.735329E-29 | -1.857865E-29 | |
| C7 | 3.434091 E-33 | -3.218306E-32 | 8.501230E-32 | -2.252218E-33 | 6.594092E-34 | |
| C8 | 0.000000E+00 | 0.000000E+00 | 0.000000E+00 | 0.000000E+00 | 0.000000E+00 | |
| C9 | 0.000000E+00 | 0.000000E+00 | 0.000000E+00 | 0.000000E+00 | 0.000000E+00 | |
| | | | | | | |
| FLAECHE | 37 | 39 | | | | |
| | | | | | | |
| K | 0 | 0 | | | | |
| C1 | -1.945342E-10 | -5.117066E-08 | | | | |
| C2 | -3.072667E-12 | 1.601404E-12 | | | | |
| C3 | 1.392672E-16 | 1.103417E-17 | | | | |
| C4 | -1.594346E-21 | -7.047636E-22 | | | | |
| C5 | -5.987158E-26 | -3.288333E-26 | | | | |
| C6 | 2.240055E-30 | 1.485188E-30 | | | | |
| C7 | 0.000000E+00 | -1.523531E-35 | | | | |
| C8 | 0.000000E+00 | 0.000000E+00 | | | | |
| C9 | 0.000000E+00 | 0.000000E+00 | | | | |

**Tabelle 4**

| NA: 1,25 ; Feld: 26 mm x 5,5 mm ; WL: 193,3 nm | | | | | | |
|---|---|---|---|---|---|---|
| FLAECHE | RADIEN | | DICKEN | GLAESER | 193.3 nm | 1/2 DURCHM |
| 0 | 0.000000 | | 81.909100 | | 1.00000000 | 60.033 |
| 1 | 2048.443266 | | 21.250400 | SIO2 | 1.56032610 | 84.944 |
| 2 | -397.145026 | | 0.999674 | | 1.00000000 | 86.678 |
| 3 | 0.000000 | | 9.999836 | SIO2 | 1.56032610 | 88.251 |
| 4 | 0.000000 | | 0.999631 | | 1.00000000 | 89.202 |
| 5 | 148.901602 | | 50.000000 | SIO2 | 1.56032610 | 94.513 |
| 6 | 357.459757 | | 52.494455 | | 1.00000000 | 89.210 |
| 7 | 183.941368 | | 34.086800 | SIO2 | 1.56032610 | 80.169 |
| 8 | -464.124393 | AS | 3.490723 | | 1.00000000 | 76.925 |
| 9 | 91.427855 | | 50.000000 | SIO2 | 1.56032610 | 63.072 |
| 10 | 93.895791 | | 11.512540 | | 1.00000000 | 42.632 |
| 11 | 0.000000 | | 9.998981 | SIO2 | 1.56032610 | 41.869 |
| 12 | 0.000000 | | 9.386987 | | 1.00000000 | 38.436 |
| 13 | -94.982271 | | 50.000000 | SIO2 | 1.56032610 | 38.838 |
| 14 | -86.138668 | | 8.374122 | | 1.00000000 | 54.696 |
| 15 | -74.540104 | | 38.657300 | SIO2 | 1.56032610 | 55.419 |
| 16 | -382.564885 | | 13.037213 | | 1.00000000 | 82.587 |
| 17 | -382.167395 | | 50.066100 | SIO2 | 1.56032610 | 90.480 |
| 18 | -117.361983 | | 4.455250 | | 1.00000000 | 96.112 |
| 19 | -408.042301 | AS | 43.871600 | SIO2 | 1.56032610 | 102.130 |
| 20 | -177.569466 | | 9.816927 | | 1.00000000 | 106.603 |
| 21 | 289.476867 | | 27.848300 | SIO2 | 1.56032610 | 100.728 |
| 22 | 6501.491211 | | 0.998760 | | 1.00000000 | 98.745 |
| 23 | 224.530994 | | 27.157000 | SIO2 | 1.56032610 | 92.812 |
| 24 | 2986.561502 | AS | 75.000000 | | 1.00000000 | 89.569 |
| 25 | 0.000000 | | -226.222510 | REFL | 1.00000000 | 89.510 |
| 26 | 106.828577 | AS | -12.500000 | SIO2 | 1.56032610 | 77.673 |
| 27 | 1042.751231 | | -49.965582 | | 1.00000000 | 94.062 |
| 28 | 111.149211 | | -12.500000 | SIO2 | 1.56032610 | 94.838 |
| 29 | 212.774328 | | -26.106409 | | 1.00000000 | 122.137 |
| 30 | 155.022997 | | 26.106409 | REFL | 1.00000000 | 124.612 |
| 31 | 212.774328 | | 12.500000 | SIO2 | 1.56032610 | 122.115 |
| 32 | 111.149211 | | 49.965582 | | 1.00000000 | 94.710 |
| 33 | 1042.751231 | | 12.500000 | SIO2 | 1.56032610 | 93.963 |
| 34 | 106.828577 | AS | 226.222510 | | 1.00000000 | 78.916 |
| 35 | 0.000000 | | -74.219082 | REFL | 1.00000000 | 77.641 |
| 36 | 2294.592536 | | -22.331200 | SIO2 | 1.56032610 | 79.528 |
| 37 | 256.141486 | | -0.999710 | | 1.00000000 | 82.627 |
| 38 | -467.135025 | | -24.545000 | SIO2 | 1.56032610 | 89.496 |
| 39 | 691.583098 | | -0.999310 | | 1.00000000 | 90.566 |
| 40 | -233.607789 | | -45.979800 | SIO2 | 1.56032610 | 93.086 |
| 41 | -4942.551686 | | -4.660965 | | 1.00000000 | 90.501 |
| 42 | -145.114796 | | -50.000000 | SIO2 | 1.56032610 | 86.173 |
| 43 | -503.288735 | AS | -13.136267 | | 1.00000000 | 76.698 |
| 44 | 763.625290 | | -12.500000 | SIO2 | 1.56032610 | 75.648 |
| 45 | -95.483381 | AS | -39.092954 | | 1.00000000 | 66.704 |
| 46 | -6058.472160 | | -12.500000 | SIO2 | 1.56032610 | 69.545 |
| 47 | -149.880323 | AS | -15.887220 | | 1.00000000 | 73.780 |
| 48 | -503.080539 | | -30.687700 | SIO2 | 1.56032610 | 76.357 |
| 49 | 1171.552640 | | -77.445168 | | 1.00000000 | 83.009 |
| 50 | -3285.578928 | AS | -22.658500 | SIO2 | 1.56032610 | 120.317 |
| 51 | 596.398897 | | -0.998775 | | 1.00000000 | 123.080 |
| 52 | -357.977963 | | -33.153400 | SIO2 | 1.56032610 | 136.416 |
| 53 | -3248.236982 | | -1.812371 | | 1.00000000 | 136.760 |
| 54 | -308.579307 | | -49.249300 | SIO2 | 1.56032610 | 139.626 |
| 55 | 836.621146 | AS | -11.829470 | | 1.00000000 | 138.580 |
| 56 | 0.000000 | | 2.947366 | | 1.00000000 | 134.942 |
| 57 | -784.542969 | | -35.882400 | SIO2 | 1.56032610 | 134.087 |
| 58 | 1336.948853 | | -3.431255 | | 1.00000000 | 131.711 |
| 59 | -322.438168 | | -35.943900 | SIO2 | 1.56032610 | 123.107 |
| 60 | 3281.822778 | | -2.392713 | | 1.00000000 | 120.250 |
| 61 | -131.283783 | | -28.495000 | SIO2 | 1.56032610 | 95.317 |
| 62 | -199.868775 | AS | -1.086856 | | 1.00000000 | 88.629 |
| 63 | -96.539151 | | -34.303600 | SIO2 | 1.56032610 | 76.133 |
| 64 | -225.944484 | AS | -1.323326 | | 1.00000000 | 66.927 |
| 65 | -61.472761 | | -50.000000 | SIO2 | 1.56032610 | 49.298 |
| 66 | 0.000000 | | -1.000000 | H2O | 1.43681630 | 16.573 |
| 67 | 0.000000 | | 0.001593 | H2O | 1.43681630 | 15.013 |

| ASPHAERISCHE KONSTANTEN | | | | | | |
|---|---|---|---|---|---|---|
| | | | | | | |
| FLAECHE | 8 | 19 | 24 | 26 | 34 | |
| | | | | | | |
| K | 0 | 0 | 0 | 0 | 0 | |
| C1 | 7.931903E-08 | -1.177647E-08 | 1.310659E-08 | -8.713192E-08 | -8.713192E-08 | |
| C2 | 3.361972E-13 | 4.916744E-13 | 2.349673E-13 | -3.312749E-12 | -3.312749E-12 | |
| C3 | 2.733335E-16 | -1.906952E-17 | -1.627068E-17 | -1.959490E-16 | -1.959490E-16 | |
| C4 | -2.918068E-20 | 3.642462E-23 | 2.940777E-22 | -1.644695E-20 | -1.644695E-20 | |
| C5 | 1.460982E-24 | 5.759228E-27 | 1.581363E-26 | 1.961941 E-25 | 1.961941 E-25 | |
| C6 | -1.007942E-29 | -5.176777E-32 | -8.636738E-31 | -1.613799E-28 | -1.613799E-28 | |
| C7 | 0.000000E+00 | 0.000000E+00 | 0.000000E+00 | 0.000000E+00 | 0.000000E+00 | |
| C8 | 0.000000E+00 | 0.000000E+00 | 0.000000E+00 | 0.000000E+00 | 0.000000E+00 | |
| C9 | 0.000000E+00 | 0.000000E+00 | 0.000000E+00 | 0.000000E+00 | 0.000000E+00 | |
| | | | | | | |
| FLAECHE | 43 | 45 | 47 | 50 | 55 | |
| | | | | | | |
| K | 0 | 0 | 0 | 0 | 0 | |
| C1 | -3.218290E-08 | -1.408460E-08 | 3.765640E-08 | 1.544290E-08 | -9.784690E-09 | |
| C2 | 4.089760E-13 | 3.732350E-12 | 2.045650E-12 | -1.526310E-13 | 2.155450E-14 | |
| C3 | 9.461900E-17 | 5.781700E-17 | 6.726610E-17 | -1.172350E-17 | -2.664880E-17 | |
| C4 | -1.126860E-20 | 4.020440E-20 | 3.357790E-21 | -3.026260E-22 | 1.199020E-21 | |
| C5 | 1.093490E-24 | 1.811160E-24 | -5.515760E-25 | -2.050700E-28 | -2.503210E-26 | |
| C6 | -2.303040E-29 | -3.465020E-28 | 2.958290E-28 | 3.614870E-31 | 2.100160E-31 | |
| C7 | 0.000000E+00 | 0.000000E+00 | 0.000000E+00 | 0.000000E+00 | 0.000000E+00 | |
| C8 | 0.000000E+00 | 0.000000E+00 | 0.000000E+00 | 0.000000E+00 | 0.000000E+00 | |
| C9 | 0.000000E+00 | 0.000000E+00 | 0.000000E+00 | 0.000000E+00 | 0.000000E+00 | |
| | | | | | | |
| FLAECHE | 62 | 64 | | | | |
| | | | | | | |
| K | 0 | 0 | | | | |
| C1 | 2.762150E-09 | -1.082280E-07 | | | | |
| C2 | -4.067930E-12 | -9.511940E-12 | | | | |
| C3 | 4.513890E-16 | 1.146050E-15 | | | | |
| C4 | -5.070740E-20 | -1.274000E-19 | | | | |
| C5 | 1.839760E-24 | 1.594380E-23 | | | | |
| C6 | -6.225130E-29 | -5.731730E-28 | | | | |
| C7 | 0.000000E+00 | 0.000000E+00 | | | | |
| C8 | 0.000000E+00 | 0.000000E+00 | | | | |
| C9 | 0.000000E+00 | 0.000000E+00 | | | | |

**Tabelle 5**

| NA: 1,25 ; Feld: 26 mm x 4,9 mm ; WL: 193,3 nm | | | | | | |
|---|---|---|---|---|---|---|
| FLAECHE | RADIEN | | DICKEN | GLAESER | 193.3 nm | 1/2 DURCHM |
| 0 | 0.000000 | | 81.909100 | | 1.00000000 | 60.033 |
| 1 | 673.366211 | | 21.250400 | SIO2 | 1.56032610 | 86.143 |
| 2 | -352.382699 | | 1.000526 | | 1.00000000 | 86.826 |
| 3 | 0.000000 | | 9.999922 | SIO2 | 1.56032610 | 87.758 |
| 4 | 0.000000 | | 0.999828 | | 1.00000000 | 88.266 |
| 5 | 146.180992 | | 50.000000 | SIO2 | 1.56032610 | 90.960 |
| 6 | 235.663997 | | 47.614073 | | 1.00000000 | 83.553 |
| 7 | 232.803962 | | 34.086800 | SIO2 | 1.56032610 | 77.655 |
| 8 | -525.462527 | AS | 3.247857 | | 1.00000000 | 74.135 |
| 9 | 92.851551 | | 50.000000 | SIO2 | 1.56032610 | 62.809 |
| 10 | 101.676358 | | 27.396923 | | 1.00000000 | 43.995 |
| 11 | -98.402976 | | 50.000000 | SIO2 | 1.56032610 | 40.939 |
| 12 | -87.452301 | | 10.624080 | | 1.00000000 | 57.044 |
| 13 | -84.711067 | | 38.657300 | SIO2 | 1.56032610 | 58.874 |
| 14 | -263.404585 | | 18.850328 | | 1.00000000 | 81.979 |
| 15 | -324.82.7786 | | 50.066100 | SIO2 | 1.56032610 | 92.383 |
| 16 | -134.730834 | | 1.001012 | | 1.00000000 | 100.760 |
| 17 | -387.701255 | AS | 43.871600 | SIO2 | 1.56032610 | 105.897 |
| 18 | -169.182822 | | 1.411725 | | 1.00000000 | 110.197 |
| 19 | 286.958322 | | 27.848300 | SIO2 | 1.56032610 | 103.540 |
| 20 | 2339.112166 | | 1.040338 | | 1.00000000 | 101.350 |
| 21 | 215.327689 | | 27.157000 | SIO2 | 1.56032610 | 95.069 |
| 22 | 2556.542175 | AS | 72.132498 | | 1.00000000 | 92.199 |
| 23 | 0.000000 | | -222.554121 | REFL | 1.00000000 | 98.569 |
| 24 | 106.814945 | AS | -12.500000 | SIO2 | 1.56032610 | 78.634 |
| 25 | 967.943813 | | -49.007290 | | 1.00000000 | 95.483 |
| 26 | 114.522293 | | -12.500000 | SIO2 | 1.56032610 | 96.351 |
| 27 | 209.321713 | | -24.703185 | | 1.00000000 | 122.199 |
| 28 | 155.317015 | | 24.703185 | REFL | 1.00000000 | 124.370 |
| 29 | 209.321713 | | 12.500000 | SIO2 | 1.56032610 | 121.966 |
| 30 | 114.522293 | | 49.007290 | | 1.00000000 | 95.525 |
| 31 | 967.943813 | | 12.500000 | SIO2 | 1.56032610 | 93.838 |
| 32 | 106.814945 | AS | 222.554121 | | 1.00000000 | 78.764 |
| 33 | 0.000000 | | -61.000000 | REFL | 1.00000000 | 74.683 |
| 34 | 1428.935254 | | -22.331200 | SIO2 | 1.56032610 | 73.779 |
| 35 | 228.264696 | | -1.001301 | | 1.00000000 | 77.285 |
| 36 | -462.657333 | | -24.545000 | SIO2 | 1.56032610 | 84.167 |
| 37 | 885.483366 | | -1.000977 | | 1.00000000 | 85.694 |
| 38 | -231.030433 | | -45.979800 | SIO2 | 1.56032610 | 88.807 |
| 39 | 5456.439341 | | -1.000168 | | 1.00000000 | 87.032 |
| 40 | -141.980854 | | -50.000000 | SIO2 | 1.56032610 | 83.909 |
| 41 | -487.877853 | AS | -11.892025 | | 1.00000000 | 74.753 |
| 42 | 744.304505 | | -12.500000 | SIO2 | 1.56032610 | 74.160 |
| 43 | -95.471841 | AS | -30.584840 | | 1.00000000 | 66.061 |
| 44 | 17792.738608 | | -12.500000 | SIO2 | 1.56032610 | 67.093 |
| 45 | -154.563738 | AS | -17.287404 | | 1.00000000 | 71.817 |
| 46 | -452.042111 | | -30.687700 | SIO2 | 1.56032610 | 77.085 |
| 47 | 669.871673 | | -100.369522 | | 1.00000000 | 82.829 |
| 48 | 3548.735563 | AS | -22.658500 | SIO2 | 1.56032610 | 125.594 |
| 49 | 472.295389 | | -4.772413 | | 1.00000000 | 128.352 |
| 50 | -366.259271 | | -33.153400 | SIO2 | 1.56032610 | 144.068 |
| 51 | -12361.700432 | | -9.333978 | | 1.00000000 | 144.157 |
| 52 | -317.083167 | | -49.249300 | SIO2 | 1.56032610 | 146.304 |
| 53 | 962.293169 | AS | -0.700250 | | 1.00000000 | 144.982 |
| 54 | 0.000000 | | -4.992187 | | 1.00000000 | 143.559 |
| 55 | 0.000000 | | -9.997236 | SIO2 | 1.56032610 | 143.164 |
| 56 | 0.000000 | | -0.992199 | | 1.00000000 | 142.040 |
| 57 | -657.958896 | | -35.882400 | SIO2 | 1.56032610 | 139.908 |
| 58 | 1515.969802 | | -0.992804 | | 1.00000000 | 137.743 |
| 59 | -260.738714 | | -35.943900 | SIO2 | 1.56032610 | 126.043 |
| 60 | -5237.030792 | | -0.993752 | | 1.00000000 | 124.160 |
| 61 | -119.057555 | | -28.495000 | SIO2 | 1.56032610 | 94.444 |
| 62 | -163.229803 | AS | -0.992865 | | 1.00000000 | 87.366 |
| 63 | -102.409442 | | -34.303600 | SIO2 | 1.56032610 | 77.909 |
| 64 | -186.405022 | AS | -0.987636 | | 1.00000000 | 65.364 |
| 65 | -66.199250 | | -50.000000 | SIO2 | 1.56032610 | 50.686 |
| 66 | 0.000000 | | -1.000000 | H2OV | 1.43681630 | 16.566 |
| 67 | 0.000000 | | 0.001593 | H2OV | 1.43681630 | 15.013 |

| ASPHAERISCHE KONSTANTEN | | | | | | |
|---|---|---|---|---|---|---|
| | | | | | | |
| FLAECHE | 8 | 17 | 22 | 24 | 32 | |
| | | | | | | |
| K | 0 | 0 | 0 | 0 | 0 | |
| C1 | 5.233631E-08 | -1.143718E-08 | 1.521494E-08 | -8.173584E-08 | -8.173584E-08 | |
| C2 | -4.247769E-13 | 4.539000E-13 | 2.236265E-13 | -3.442666E-12 | -3.442666E-12 | |
| C3 | 2.264621E-16 | -2.603436E-17 | -2.309696E-17 | -1.945129E-16 | -1.945129E-16 | |
| C4 | -3.544742E-21 | 1.689629E-22 | 9.703692E-22 | -1.379025E-20 | -1.379025E-20 | |
| C5 | -2.689319E-24 | 9.802414E-27 | -2.535866E-26 | -1.501650E-26 | -1.501650E-26 | |
| C6 | 1.772618E-28 | -2.612406E-31 | 2.286605E-31 | -1.600981 E-28 | -1.600981.E-28 | |
| C7 | 0.000000E+00 | 0.000000E+00 | 0.000000E+00 | 0.000000E+00 | 0.000000E+00 | |
| C8 | 0.000000E+00 | 0.000000E+00 | 0.000000E+00 | 0.000000E+00 | 0.000000E+00 | |
| C9 | 0.000000E+00 | 0.000000E+00 | 0.000000E+00 | 0.000000E+00 | 0.000000E+00 | |
| | | | | | | |
| FLAECHE | 41 | 43 | 45 | 48 | 53 | |
| | | | | | | |
| K | 0 | 0 | 0 | 0 | 0 | |
| C1 | -3.218290E-08 | -1.408460E-08 | 3.765640E-08 | 1.375675E-08 | -1.293407E-08 | |
| C2 | 4.089760E-13 | 3.732350E-12 | 2.045650E-12 | -1.650648E-13 | 8.171098E-14 | |
| C3 | 9.461900E-17 | 5.781700E-17 | 6.726610E-17 | -7.725229E-18 | -2.315997E-17 | |
| C4 | -1.126860E-20 | 4.020440E-20 | 3.357790E-21 | -8.878454E-23 | 1.220861E-21 | |
| C5 | 1.093490E-24 | 1.811160E-24 | -5.515760E-25 | -3.024502E-27 | -3.871131 E-26 | |
| C6 | -2.303040E-29 | -3.465020E-28 | 2.958290E-28 | 7.260257E-31 | 8.195620E-31 | |
| C7 | 0.000000E+00 | 0.000000E+00 | 0.000000E+00 | -3.056481E-35 | -1.127163E-35 | |
| C8 | 0.000000E+00 | 0.000000E+00 | 0.000000E+00 | 5.105060E-40 | 7.656900E-41 | |
| C9 | 0.000000E+00 | 0.000000E+00 | 0.000000E+00 | 0.000000E+00 | 0.000000E+00 | |
| | | | | | | |
| FLAECHE | 62 | 64 | | | | |
| | | | | | | |
| K | 0 | 0 | | | | |
| C1 | 2.762150E-09 | -1.082280E-07 | | | | |
| C2 | -4.067930E-12 | -9.511940E-12 | | | | |
| C3 | 4.513890E-16 | 1.146050E-15 | | | | |
| C4 | -5.070740E-20 | -1.274000E-19 | | | | |
| C5 | 1.839760E-24 | 1.594380E-23 | | | | |
| C6 | -6.225130E-29 | -5.731730E-28 | | | | |
| C7 | 0.000000E+00 | 0.000000E+00 | | | | |
| C8 | 0.000000E+00 | 0.000000E+00 | | | | |
| C9 | 0.000000E+00 | 0.000000E+00 | | | | |

**Tabelle 6**

| NA: 1,55 ; Feld: 13 mm x 5 mm ; WL: 193,3 nm | | | | | | |
|---|---|---|---|---|---|---|
| FLAECHE | RADIEN | | DICKEN | GLAESER | 193.368 nm | 1/2 DURCHM |
| 0 | 0.000000 | | 30.000000 | | 1.00000000 | 28.040 |
| 1 | -45.394016 | AS | 6.635689 | SIO2 | 1.56049116 | 34.957 |
| 2 | 2151.515917 | | 16.545348 | | 1.00000000 | 46.807 |
| 3 | -83.051561 | | 28.566059 | SIO2 | 1.56049116 | 47.891 |
| 4 | -119.065543 | AS | 0.500000 | | 1.00000000 | 69.316 |
| 5 | 0.000000 | | 10.000000 | SIO2 | 1.56049116 | 94.621 |
| 6 | 0.000000 | | 1.000000 | | 1.00000000 | 99.921 |
| 7 | 2530.299735 | | 63.349995 | SIO2 | 1.56049116 | 103.248 |
| 8 | -135.649196 | | 0.500000 | | 1.00000000 | 107.463 |
| 9 | 311.093341 | | 39.925564 | SIO2 | 1.56049116 | 121.003 |
| 10 | -493.635417 | AS | 0.500000 | | 1.00000000 | 120.604 |
| 11 | 133.444606 | | 61.067502 | SIO2 | 1.56049116 | 117.509 |
| 12 | 374.542254 | | 0.500000 | | 1.00000000 | 113.040 |
| 13 | 84.632149 | | 51.590152 | SIO2 | 1.56049116 | 81.754 |
| 14 | 88.648479 | | 25.127474 | | 1.00000000 | 63.232 |
| 15 | 307.626412 | AS | 9.334872 | SIO2 | 1.56049116 | 62.312 |
| 16 | 43.760171 | | 42.700144 | | 1.00000000 | 40.624 |
| 17 | -62.866922 | | 7.971264 | SIO2 | 1.56049116 | 40.618 |
| 18 | -239.625085 | AS | 24.317933 | | 1.00000000 | 45.475 |
| 19 | -50.648163 | | 40.253476 | SIO2 | 1.56049116 | 45.709 |
| 20 | -149.875156 | | 0.500000 | | 1.00000000 | 83.162 |
| 21 | -2133.410799 | AS | 63.096865 | SIO2 | 1.56049116 | 100.727 |
| 22 | -125.285708 | | 0.500000 | | 1.00000000 | 109.440 |
| 23 | -2601.1.027051 | | 65.192910 | SIO2 | 1.56049116 | 140.404 |
| 24 | -203.948605 | | 0.500000 | | 1.00000000 | 142.582 |
| 25 | 193.874995 | | 64.570959 | SIO2 | 1.56049116 | 136.803 |
| 26 | -1131.653398 | AS | 0.500000 | | 1.00000000 | 133.946 |
| 27 | 101.431520 | | 69.833756 | CAF2 | 1.50110592 | 97.569 |
| 28 | 92.297418 | | 0.500000 | | 1.00000000 | 69.924 |
| 29 | 70.344368 | | 54.208844 | CAF2 | 1.50110592 | 63.058 |
| 30 | 43.124915 | AS | 48.219058 | | 1.00000000 | 30.693 |
| 31 | -49.524613 | | 19.920470 | CAF2 | 1.50110592 | 32.075 |
| 32 | 458.868681 | | 67.965960 | SIO2 | 1.56049116 | 75.933 |
| 33 | -92.104256 | | 0.500000 | | 1.00000000 | 83.821 |
| 34 | 518.816092 | | 40.830736 | SIO2 | 1.56049116 | 130.987 |
| 35 | -593.727113 | | 0.500000 | | 1.00000000 | 133.184 |
| 36 | 554.922603 | | 47.451002 | SIO2 | 1.56049116 | 141.932 |
| 37 | -313.882110 | AS | 54.465535 | | 1.00000000 | 142.459 |
| 38 | 0.000000 | | 10.000000 | SIO2 | 1.56049116 | 143.113 |
| 39 | 0.000000 | | 5.000000 | | 1.00000000 | 143.170 |
| 40 | 388.722555 | | 30.775375 | SIO2 | 1.56049116 | 143.454 |
| 41 | 1862.901509 | | 0.997362 | | 1.00000000 | 142.272 |
| 42 | 198.712780 | AS | 66.525407 | SIO2 | 1.56049116 | 136.261 |
| 43 | -514.840049 | | 0.500000 | | 1.00000000 | 134.178 |
| 44 | 85.045649 | | 44.185930 | SIO2 | 1.56049116 | 81.693 |
| 45 | 145.661446 | AS | 17.247660 | | 1.00000000 | 74.191 |
| 46 | 0.000000 | | -16.348223 | | 1.00000000 | 80.280 |
| 47 | 92.090812 | | 57.694536 | CAF2 | 1.50110592 | 67.945 |
| 48 | 47.458170 | AS | 1.000000 | | 1.00000000 | 28.748 |
| 49 | 38.518298 | | 19.946111 | LUAG | 2.14000000 | 25.820 |
| 50 | 0.000000 | | 3.000000 | CYCLOHEXAN | 1.65000000 | 15.292 |
| 51 | 0.000000 | | 0.000000 | CYCLOHEXAN | 1.65000000 | 7.033 |

| ASPHAERISCHE KONSTANTEN | | | | | | |
|---|---|---|---|---|---|---|
| FLAECHE | 1 | 4 | 10 | 15 | 18 | |
| | | | | | | |
| K | 0 | 0 | 0 | 0 | 0 | |
| C1 | 2.222335E-06 | 2.157480E-07 | 1.213751E-08 | -7.024709E-07 | -9.624575E-07 | |
| C2 | -2.960106E-10 | -3.703032E-11 | 3.933709E-12 | 1.889675E-10 | 3.626064E-10 | |
| C3 | 4.099432E-14 | -7.688081E-15 | -2.029701E-16 | -3.670917E-14 | -7.017458E-14 | |
| C4 | 8.830630E-18 | 1.855665E-18 | 4.960091E-21 | 7.174517E-18 | 3.203346E-17 | |
| C5 | 2.738367E-21 | -2.075437E-22 | -9.428631 E-26 | -1.086191E-21 | 3.301669E-21 | |
| C6 | -4.634945E-24 | 2.467311E-27 | 2.722400E-30 | 7.269040E-26 | 1.937988E-25 | |
| C7 | 0.000000E+00 | 0.000000E+00 | 0.000000E+00 | 0.000000E+00 | 0.000000E+00 | |
| C8 | 0.000000E+00 | 0.000000E+00 | 0.000000E+00 | 0.000000E+00 | 0.000000E+00 | |
| C9 | 0.000000E+00 | 0.000000E+00 | 0.000000E+00 | 0.000000E+00 | 0.000000E+00 | |
| | | | | | | |
| FLAECHE | 21 | 26 | 30 | 37 | 42 | |
| | | | | | | |
| K | 0 | 0 | 0 | 0 | 0 | |
| C1 | -1.923992E-07 | 2.460562E-08 | 2.978434E-07 | 4.796558E-08 | -5.884188E-09 | |
| C2 | 1.538439E-11 | -9.931095E-13 | -2.509878E-10 | -1.062531 E-12 | -1.581977E-12 | |
| C3 | -5.149355E-16 | 1.592698E-16 | -2.512252E-13 | 2.364210E-17 | -3.047715E-17 | |
| C4 | -2.897216E-20 | -1.093197E-20 | -6.241269E-17 | -5.051762E-22 | 1.097254E-22 | |
| C5 | 3.826170E-24 | 3.840316E-25 | -2.651403E-21 | 1.467614E-26 | 4.543670E-26 | |
| C6 | -1.269936E-28 | -5.374727E-30 | -7.813369E-25 | -8.111221 E-32 | -1.393249E-31 | |
| C7 | 0.000000E+00 | 0.000000E+00 | 0.000000E+00 | 0.000000E+00 | 0.000000E+00 | |
| C8 | 0.000000E+00 | 0.000000E+00 | 0.000000E+00 | 0.000000E+00 | 0.000000E+00 | |
| C9 | 0.000000E+00 | 0.000000E+00 | 0.000000E+00 | 0.000000E+00 | 0.000000E+00 | |
| | | | | | | |
| FLAECHE | 45 | 48 | | | | |
| | | | | | | |
| K | 0 | 0 | | | | |
| C1 | 2.457177E-07 | -4.614167E-06 | | | | |
| C2 | -2.166219E-11 | 7.262309E-09 | | | | |
| C3 | 2.975343E-15 | -1.885463E-11 | | | | |
| C4 | -5.958384E-1.9 | 3.520215E-14 | | | | |
| C5 | 2.562257E-24 | -3.028402E-17 | | | | |
| C6 | 6.910021 E-27 | 1.073889E-20 | | | | |
| C7 | 0.000000E+00 | 0.000000E+00 | | | | |
| C8 | 0.000000E+00 | 0.000000E+00 | | | | |
| C9 | 0.000000E+00 | 0.000000E+00 | | | | |

**Tabelle 7**

| | **NumAp** | 1,32 | | | | |
|---|---|---|---|---|---|---|
| | **y'** | 15,16 | | | | |
| | **OBERFLÄCHE** | **RADIEN** | **DICKEN** | **MATERIAL** | **INDEX** | **1/2 DURCHMESSER** |
| | **0** | 0,000000 | 113,754200 | | | 60,6 |
| | **1** | 0,000000 | 8,000000 | SILUV | 1,560482 | 100,5 |
| | **2** | 0,000000 | 6,000000 | | | 102,2 |
| | **3** | 930,923922 | 52,000000 | SILUV | 1,560482 | 106,4 |
| | **4** | -256,201417 | 1,000000 | | | 110,0 |
| | **5** | 164,802556 | 35,773100 | SILUV | 1,560482 | 110,4 |
| | **6** | 341,545138 | 15,747900 | | | 107,3 |
| | **7** | 147,535157 | 56,488000 | SILUV | 1,560482 | 97,6 |
| | **8** | -647,942934 | 4,145000 | | | 91,4 |
| | **9** | -536,071478 | 18,297900 | SILUV | 1,560482 | 89,4 |
| | **10** | 180,585020 | 1,000000 | | | 71,6 |
| | **11** | 82,247096 | 28,431900 | SILUV | 1,560482 | 64,3 |
| | **12** | 121,636868 | 21,482876 | | | 56,7 |
| | **13** | 0,000000 | 10,000000 | SILUV | 1,560482 | 51,2 |
| | **14** | 0,000000 | 35,037652 | | | 47,0 |
| | **15** | -89,601791 | 44,878000 | SILUV | 1,560482 | 50,3 |
| | **16** | -203,308357 | 49,953200 | | | 72,8 |
| | **17** | -333,934057 | 37,672400 | SILUV | 1,560482 | 98,4 |
| | **18** | -153,471299 | 1,000000 | | | 104,5 |
| | **19** | -588,427923 | 47,008300 | SILUV | 1,560482 | 113,3 |
| | **20** | -177,569099 | 1,000000 | | | 116,9 |
| | **21** | 1289,635452 | 32,747800 | SILUV | 1,560482 | 114,7 |
| | **22** | -409,790925 | 1,000000 | | | 114,2 |
| | **23** | 196,979548 | 36,289500 | SILUV | 1,560482 | 103,1 |
| | **24** | 2948,592605 | 72,000000 | | | 99,3 |
| | **25** | 0,000000 | -204,306500 | REFL | | 68,2 |
| | **26** | 120,965260 | -15,000000 | SILUV | 1,560482 | 67,6 |
| | **27** | 177,749728 | -28,181900 | | | 76,7 |
| | **28** | 106,065668 | -18,000000 | SILUV | 1,560482 | 81,8 |
| | **29** | 323,567743 | -34,983200 | | | 113,6 |
| | **30** | 165,900097 | 34,983200 | REFL | | 119,8 |
| | **31** | 323,567743 | 18,000000 | SILUV | 1,560482 | 115,6 |
| | **32** | 106,065668 | 28,181900 | | | 88,3 |
| | **33** | 177,749728 | 15,000000 | SILUV | 1,560482 | 87,2 |
| | **34** | 120,965260 | 204,306500 | | | 79,0 |
| | **35** | 0,000000 | -72,000000 | REFL | | 64,8 |
| | **36** | 462,513697 | -24,493400 | SILUV | 1,560482 | 92,9 |
| | **37** | 196,771640 | -1,000000 | | | 96,3 |
| | **38** | -996,046057 | -27,579900 | SILUV | 1,560482 | 106,5 |
| | **39** | 480,084349 | -1,000000 | | | 108,1 |
| | **40** | -260,478322 | -35,771400 | SILUV | 1,560482 | 113,0 |
| | **41** | -3444,700345 | -1,000000 | | | 111,8 |
| | **42** | -189,044457 | -50,000000 | SILUV | 1,560482 | 107,6 |
| | **43** | -630,985131 | -43,198700 | | | 99,6 |
| | **44** | 675,856906 | -10,000000 | SILUV | 1,560482 | 88,6 |
| | **45** | -117,005373 | -46,536000 | | | 79,9 |
| | **46** | 214,318111 | -10,000000 | SILUV | 1,560482 | 79,8 |
| | **47** | -191,854301 | -23,664400 | | | 93,5 |
| | **48** | 1573,576031 | -31,506600 | SILUV | 1,560482 | 94,4 |
| | **49** | 214,330939 | -1,000000 | | | 100,3 |
| | **50** | -322,859172 | -33,185600. | SILUV | 1,560482 | 133,7 |
| | **51** | -1112,917245 | -10,017200 | | | 135,5 |
| | **52** | -2810,857827 | -22,000000 | SILUV | 1,560482 | 137,0 |
| | **53** | -920,532878 | -42,079900 | | | 145,9 |
| | **54** | 707,503574 | -62,025500 | SILUV | 1,560482 | 146,3 |
| | **55** | 238,350224 | -1,000000 | | | 157,1 |
| | **56** | -17926,557240 | -62,132800 | SILUV | 1,560482 | 178,0 |
| | **57** | 336,363925 | -2,000000 | | | 179,9 |
| | **58** | 0,000000 | -10,000000 | SILUV | 1,560482 | 179,0 |
| | **59** | 0,000000 | -51,180119 | | | 178,9 |
| | **60** | 0,000000 | 48,529765 | | | 178,0 |
| | **61** | -303,574400 | -68,224400 | SILUV | 1,560482 | 179,0 |
| | **62** | -19950,680601 | -7,986643 | | | 177,0 |
| | **63** | -182,034245 | -77,612200 | SILUV | 1,560482 | 150,7 |
| | **64** | -459,526735 | -1,000000 | | | 141,5 |
| | **65** | -130,446554 | -49,999900 | SILUV | 1,560482 | 105,5 |
| | **66** | -393,038792 | -1,000000 | | | 91,8 |
| | **67** | -76,745086 | -43,335100 | SILUV | 1,560482 | 62,7 |
| | **68** | 0,000000 | -1,000000 | H2OV | 1,435876 | 45,3 |
| | **69** | 0,000000 | -13,000000 | SILUV | 1,560482 | 43,0 |
| | **70** | 0,000000 | -3,000396 | H2OV | 1,435876 | 22,2 |
| | **71** | 0,000000 | 0,000000 | | | 15,2 |

| **ASPHÄRISCHE KONSTANTEN** | | | | | | |
|---|---|---|---|---|---|---|
| **OBERFL.** | | 9 | 17 | 2 4 | 43 | 47 |
| **K** | | 0 | 0 | 0 | 0 | 0 |
| **C1** | | -6,152794E-08 | -7,450948E-09 | 2,397578E+00 | 8 -1.544441e | 8,902497E-08 |
| **C2** | | 9,072358E-12 | -4,968691E-13 | -3,992688E-01 3 | 4.805552e | -4,455899E-12 |
| **C3** | | -7,620162E-16 | -1,804573E-17 | 7,587147E-01 | 8 -6.813171e | 3,521620E-16 |
| **C4** | | 2,116045E-20 | 1,214276E-21 | -4,079078E-02 | 3 -4.666592e | -2,121932E-20 |
| **C5** | | 2,963576E-24 | 5,493721E-27 | -1,807190E-02 6 | 1.242732e | 2,642521E-25 |
| **C6** | | -3,075337E-28 | -5,299803E-30 | 1,560768E-03 0 | -9.557499e | 1,245058E-28 |
| **C7** | | 9,068617E-33 | 1,870242E-34 | -4,466502E-03 | 5 2.284660e | -6,144810E-33 |
| | | | | | | |
| **OBERFL.** | | 48 | 51 | 5 3 | 54 | 64 |
| **K** | | 0 | 0 | 0 | 0 | 0 |
| **C1** | | 2,768189E-08 | 1,787600E-08 | -3,738135E+00 8 | 1.728194e | 3,264015E-08 |
| **C2** | | -1,657627E-12 | -3,785102E-13 | -8,195730E-01 3 | -6.690131e | -2,291400E-12 |
| **C3** | | 1,596547E-17 | -9,909771E-17 | 1,196846E-016 | 1.379584e | 1,419559E-16 |
| **C4** | | -5,508505E-21 | 4,442167E-21 | -2,578914E-02 | -5.773921e | -6,671541E-21 |
| **C5** | | 5,521223E-25 | -1,566662E-25 | -3,008537E-02 6 | 1.736082e | 2,032317E-25 |
| **C6** | | -1,359008E-28 | 6,868774E-30 | 1,836351E-03 0 | -3.718468e | -3,619015E-30 |
| **C7** | | 8,927631E-33 | -1,167559E-34 | -2,233659E-03 | 5 6.530703e | 2,871756E-35 |
| | | | | | | |
| **OBERFL.** | | 66 | | | | |
| **K** | | 0 | | | | |
| **C1** | | -6,538685E-08 | | | | |
| **C2** | | -1,101880E-13 | | | | |
| **C3** | | -2,522891E-16 | | | | |
| **C4** | | 2,782014E-20 | | | | |
| **C5** | | -3,073204E-24 | | | | |
| **C6** | | 1,726081 E-28 | | | | |
| **C7** | | -5,631877E-33 | | | | |

## Patentansprüche

1. Projektionsobjektiv für die Lithographie, mit einer optischen Anordnung (12; 22; 32; 42; 52) optischer Elemente zwischen einer Objektebene (O) und einer Bildebene (B), wobei die Anordnung (12; 22; 32; 42; 52) zumindest eine Zwischenbildebene (Z) aufweist, wobei die Anordnung (12; 22; 32; 42; 52) weiterhin zumindest zwei Korrekturelemente (K₁, K₂) zur Korrektur von Abbildungsfehlern aufweist, von denen ein erstes Korrekturelement (K₁) optisch zumindest in Nähe einer Pupillenebene (P) und ein zweites Korrekturelement (K₂) in einem Bereich angeordnet ist, der weder einer Pupillenebene (P) noch einer Feldebene (F) optisch nahe ist.

2. Projektionsobjektiv nach Anspruch 1, wobei die Position des ersten Korrekturelements (K₁) so gewählt ist, dass ein Verhältnis aus Hauptstrahlhöhe zu Randstrahlhöhe an dieser Position dem Betrage nach kleiner als 1/n ist, wobei n = 5, n = 10, oder n = 20 ist.

3. Projektionsobjektiv nach Anspruch 1 oder 2, wobei die Position des zweiten Korrekturelements (K₂) so gewählt ist, dass ein Verhältnis aus Hauptstrahlhöhe zu Randstrahlhöhe an dieser Position dem Betrage nach größer als 1/m, jedoch kleiner als p/10 ist, wobei m = 20, oder m = 10, oder m = 5, und p = 55, oder p = 35, oder p = 25, oder p = 20, oder p = 17 gilt.

4. Projektionsobjektiv nach einem der Ansprüche 1 bis 3, wobei die Anordnung (12) optischer Elemente in Lichtausbreitungsrichtung gesehen aufweist:
- eine erste Baugruppe (G₁), die die Objektebene (O) über eine erste Pupillenebene (P₁) in die Zwischenbildebene (Z) abbildet,
- eine zweite Baugruppe (G₂), die die Zwischenbildebene (Z) über eine zweite Pupillenebene (P₂) in die Bildebene (B) abbildet,
wobei das erste Korrekturelement (K₁) optisch zumindest in Nähe der zweiten Pupillenebene (P₂) und das zweite Korrekturelement (K₂) nach der Zwischenbildebene (Z) und vor der zweiten Pupillenebene (P₂) angeordnet ist und weder der Zwischenbildebene (Z) noch der zweiten Pupillenebene (P₂) optisch nahe ist.

5. Projektionsobjektiv nach einem der Ansprüche 1 bis 3, wobei die Anordnung (22) optischer Elemente in Lichtausbreitungsrichtung gesehen aufweist:
- eine erste Baugruppe (G₁), die die Objektebene (O) über eine erste Pupillenebene (P₁) in die Zwischenbildebene (Z) abbildet,
- eine zweite Baugruppe (G₂), die die Zwischenbildebene (Z) über eine zweite Pupillenebene (P₂) in die Bildebene (B) abbildet,
wobei das erste Korrekturelement (K₁) optisch zumindest in Nähe der zweiten Pupillenebene (P₂) angeordnet ist und das zweite Korrekturelement (K₂) vor der ersten Pupillenebene (P₁) angeordnet ist und weder zur Objektebene (O) noch zu der ersten Pupillenebene (P₁) optisch nahe ist.

6. Projektionsobjektiv nach einem der Ansprüche 1 bis 3, wobei die Anordnung (32) optischer Elemente in Lichtausbreitungsrichtung gesehen aufweist:
- eine erste Baugruppe (G₁), die die Objektebene (O) über eine erste Pupillenebene (P₁) in eine erste Zwischenbildebene (Z) abbildet,
- eine zweite Baugruppe (G₂), die die erste Zwischenbildebene (Z₁) über eine zweite Pupillenebene (P₂) in eine zweite Zwischenbildebene (Z) abbildet,
- eine dritte Baugruppe (G₃), die die zweite Zwischenbildebene (Z₂) über eine dritte Pupillenebene (P₃) in die Bildebene (B) abbildet,
wobei das erste Korrekturelement (K₁) optisch zumindest in Nähe der ersten Pupillenebene (P₁) und das zweite Korrekturelement (K₂) zwischen der ersten Pupillenebene (P₁) und der ersten Zwischenbildebene (Z₁) angeordnet ist und weder zu der ersten Pupillenebene (P₁) noch zu der ersten Zwischenbildebene (Z₁) optisch nahe ist.

7. Projektionsobjektiv nach einem der Ansprüche 1 bis 3, wobei die Anordnung (42) optischer Elemente in Lichtausbreitungsrichtung gesehen aufweist:
- eine erste Baugruppe (G₁), die die Objektebene (O) über eine erste Pupillenebene (P₁) in eine erste Zwischenbildebene (Z₁) abbildet,
- eine zweite Baugruppe (G₂), die die erste Zwischenbildebene (Z₁) über eine zweite Pupillenebene (P₁) in eine zweite Zwischenbildebene (Z₂) abbildet,
- eine dritte Baugruppe (G₃), die die zweite Zwischenbildebene (Z₂) über eine dritte Pupillenebene (P₃) in die Bildebene abbildet,
wobei das erste Korrekturelement (K₁) optisch zumindest in Nähe der ersten Pupillenebene (P₁) und das zweite Korrekturelement (K₂) zwischen der Objektebene(O) und der ersten Pupillenebene (P₁) angeordnet ist und weder zur Objektebene (O) noch zur ersten Pupillenebene (P₁) optisch nahe ist.

8. Projektionsobjektiv nach Anspruch 7, wobei ein drittes Korrekturelement (K₃) optisch zumindest in Nähe der dritten Pupillenebene (P₃) angeordnet ist.

9. Projektionsobjektiv nach einem der Ansprüche 1 bis 3, wobei die Anordnung (42) optischer Elemente in Lichtausbreitungsrichtung gesehen aufweist:
- eine erste Baugruppe (G₁), die die Objektebene (O) über eine erste Pupillenebene (P₁) in eine erste Zwischenbildebene (Z₁) abbildet,
- eine zweite Baugruppe (G₂), die die erste Zwischenbildebene (Z₁) über eine zweite Pupillenebene (G₂) in eine zweite Zwischenbildebene (Z₂) abbildet,
- eine dritte Baugruppe (G₃), die die zweite Zwischenbildebene (Z₂) über eine dritte Pupillenebene (P₃) in die Bildebene (B) abbildet,
wobei das erste Korrekturelement (K₁) optisch zumindest in Nähe der dritten Pupillenebene (P₃) und das zweite Korrekturelement (K₂) zwischen der Objektebene (O) und der ersten Pupillenebene (P₁) angeordnet ist und weder zur Objektebene (O) noch zur ersten Pupillenebene (P₁) optisch nahe ist.

10. Projektionsobjektiv nach einem der Ansprüche 1 bis 3, wobei die Anordnung (52) optischer Elemente in Lichtausbreitungsrichtung gesehen aufweist:
- eine erste Baugruppe (G₁), die die Objektebene (O) über eine erste Pupillenebene (P₁) in die Zwischenbildebene (Z) abbildet,
- eine zweite Baugruppe (G₂), die die Zwischenbildebene (Z) in die Bildebene (B) abbildet,
wobei das erste Korrekturelement (K₁) optisch zumindest in Nähe der zweiten Pupillenebene (P₂) und das zweite Korrekturelement (K₂) zwischen der Objektebene (O) und der ersten Pupillenebene (P₁) angeordnet ist und weder der Objektebene (O) noch der ersten Pupillenebene (P₁) optisch nahe ist.

11. Projektionsobjektiv nach einem der Ansprüche 1 bis 10, wobei die Anordnung (12; 22; 32; 42; 52) genau zwei Korrekturelemente (K₁, K₂) oder drei Korrekturelemente (K₁, K₂, K₃) aufweist.

12. Projektionsobjektiv nach einem der Ansprüche 1 bis 11, wobei zumindest eines der Korrekturelemente (K₁, K₂, K₃) während des Betriebs des Projektionsobjektivs austauschbar ist.

13. Projektionsobjektiv nach einem der Ansprüche 1 bis 12, wobei zumindest eines der Korrekturelemente (K₁, K₂, K₃) eine Planplatte ist.

14. Projektionsobjektiv nach einem der Ansprüche 1 bis 13, wobei zumindest eines der Korrekturelemente (K₁, K₂) eine Asphärisierung aufweist.

15. Projektionsobjektiv nach einem der Ansprüche 1 bis 14, wobei zumindest eines der Korrekturelemente (K₁, K₂, K₃) aktiv verformbar ist.

16. Projektionsobjektiv nach einem der Ansprüche 1 bis 15, wobei zumindest eines der Korrekturelemente (K₁, K₂, K₃) thermisch manipulierbar ist.

17. Projektionsobjektiv nach einem der Ansprüche 1 bis 16, wobei zumindest eines der Korrekturelemente (K₁, K₂, K₃) lageverstellbar ist.
